# EUROPEAN PATENT APPLICATION

(11) **EP 4 598 294 A1**
(43) Date of publication of application: **06.08.2025**
(21) Application number: 24195315.7
(22) Date of filing: 20.08.2024
(51) Int. Cl.: H10B 12/00, H10D 30/67

(54) **SEMICONDUCTOR MEMORY DEVICE**

(30) Priority: 05.02.2024 KR 20240017310
(71) Applicant: Samsung Electronics Co., Ltd., Gyeonggi-do, 16677 (KR); IUCF-HYU (Industry-University Cooperation Foundation Hanyang University), Seoul (KR)
(72) Inventor: PARK, Jin Seong, Seoul (KR); KHO, Ji Hyun, 16677 Suwon-si, Gyeonggi-do (KR); LEE, Seung Hee, 16677 Suwon-si, Gyeonggi-do (KR); KIM, Dong Gyu, Seoul (KR); KIM, Yu Rim, 16677 Suwon-si, Gyeonggi-do (KR); TAK, Yong Suk, 16677 Suwon-si, Gyeonggi-do (KR)
(74) Representative: Kuhnen & Wacker Patent- und Rechtsanwaltsbüro PartG mbB

(57) **Abstract**

A semiconductor memory device includes a bitline extending in a first direction, on a substrate, a first channel pattern disposed on the bitline, a second channel pattern disposed on the bitline and spaced apart from the first channel pattern in the first direction, a first wordline disposed between the first and second channel patterns and extending in a second direction, a second wordline disposed between the first and second channel patterns, extending in the second direction, and spaced apart from the first wordline in the first direction, and first and second capacitors connected to the first and second channel patterns, on the first and second channel patterns.

## Description

### CROSS-REFERENCE TO RELATED APPLICATION

This application claims priority to Korean Patent Application No. 10-2024-0017310 filed on February 5, 2024 in the Korean Intellectual Property Office, and all the benefits accruing therefrom under 35 U.S.C. 119, the contents of which are herein incorporated by reference in its entirety.

### BACKGROUND

To meet consumers' demands for excellent performance and affordable prices, an increase in the integration density of semiconductor memory devices is required, particularly, because the integration density of semiconductor memory devices is a critical factor in determining the price of products.

For two-dimensional (2D) or planar semiconductor memory devices, their integration density is primarily determined by the area occupied by each unit memory cell and is significantly influenced by the level of fine pattern formation technology. However, due to the need for highly expensive equipment for the miniaturization and refinement of patterns, the integration density of 2D semiconductor memory devices is increasing but remains limited. Consequently, semiconductor memory devices that include vertical channel transistors (VCTs) with channels extending in a vertical direction are being proposed.

### SUMMARY

In general, in some aspects, the present disclosure is directed toward a semiconductor memory device having improved integration density and electrical characteristics.

According to some implementations, the present disclosure is directed to a semiconductor memory device comprising a bitline extending in a first direction, on a substrate, a first channel pattern disposed on the bitline, a second channel pattern disposed on the bitline and spaced apart from the first channel pattern in the first direction, a first wordline disposed between the first and second channel patterns and extending in a second direction, a second wordline disposed between the first and second channel patterns, extending in the second direction, and spaced apart from the first wordline in the first direction, and first and second capacitors connected to the first and second channel patterns, on the first and second channel patterns, wherein each of the first and second channel patterns includes a first metal oxide pattern, which includes indium (In), gallium (Ga), and tin (Sn), in a composition distribution of the first metal oxide pattern, positions of In peaks differ from positions of Ga peaks, and a number of the In peaks differs from a number of the Ga peaks.

According to some implementations, the present disclosureis directed to a semiconductor memory device comprising a bitline extending in a first direction, on a substrate, a protruding insulating pattern disposed on the bitline and including a channel trench, which extends in a second direction that intersects the first direction, a channel structure disposed on the bitline within the channel trench, a first wordline disposed on the channel structure and extending in the second direction, a second wordline disposed on the channel structure, extending in the second direction, and spaced apart from the first wordline in the first direction, and capacitors disposed on the channel structure and connected to the channel structure, wherein the channel structure includes a first metal oxide pattern, which includes a plurality of oxide semiconductor regions, each of the oxide semiconductor regions includes indium (In), gallium (Ga), and tin (Sn), each of the oxide semiconductor regions extends along sidewalls and a bottom surface of the channel trench, and in a composition distribution of the first metal oxide pattern, each of the oxide semiconductor regions includes a plurality of In peaks.

According to some implementations, the present disclosureis directed to a semiconductor memory device comprising a periphery gate structure on a substrate, a bitline disposed on the periphery gate structure and extending in a first direction, a channel structure disposed on the bitline and including a horizontal portion and first and second vertical portions, which protrude from the horizontal portion, a first wordline disposed on the channel structure and extending in a second direction, a second wordline disposed on the channel structure, extending in the second direction, and spaced apart from the first wordline in the first direction, a gate separation pattern disposed on the horizontal portion of the channel structure and separating the first and second wordlines, landing pads disposed on the channel structure and connected to the channel structure, and data storage patterns disposed on the landing pads, wherein the channel structure includes a first metal oxide pattern, which includes indium (In), gallium (Ga), and tin (Sn), a ratio of Sn among metal elements included in the first metal oxide pattern is between 10 at% and 30 at%, and in a composition distribution of the first metal oxide pattern, a ratio of a number of In peaks to a number of Ga peaks is 2 or greater.

### BRIEF DESCRIPTION OF THE DRAWINGS

Example implementations will be more clearly understood from the following detailed description, taken in conjunction with the accompanying drawings.
FIG. 1 is a layout view showing an example of a semiconductor memory device according to some some implementations.
FIG. 2 is a cross-sectional view taken along lines A-A and B-B of FIG. 1 according to some implementations.
FIG. 3 is a cross-sectional view taken along lines C-C and D-D of FIG. 1 according to some implementations.
FIG. 4 is an enlarged cross-sectional view of an example of a part P of FIG. 2 according to some implementations.
FIG. 5 is an enlarged cross-sectional view of an example of a part of a first metal oxide pattern of FIG. 4 according to some implementations.
FIG. 6 is a graph showing an example of a composition distribution of metals included in the first metal oxide pattern along "SCAN LINE" of FIG. 5 according to some implementations.
FIGS. 7 to 10 are diagrams showing an example of a semiconductor memory devices according to some implementations.
FIGS. 11 and 12 are diagrams showing an example of a semiconductor memory device according to some implementations.
FIGS. 13 to 16 are diagrams showing an example of a semiconductor memory device according to some implementations.
FIGS. 17 to 20 are diagrams showing examples of semiconductor memory devices according to some implementations.
FIG. 21 is a flowchart showing an example of a method of manufacturing a semiconductor memory device according to some implementations.
FIG. 22 is a flowchart showing an example of a method of manufacturing a semiconductor memory device according to some implementations.
FIG. 23 is a timing diagram showing an example of a deposition cycle for forming each metal oxide film of FIGS. 21 and 22 according to some implementations.
FIG. 24 is a diagram showing example compositions of thin films analyzed through X-ray fluorescence spectroscopy (XRF) according to some implementations.
FIG. 25 is a diagram showing example compositions of thin films analyzed through X-ray photoelectron spectroscopy (XPS) according to some implementations.
FIG. 26 is a graph showing an example of XPS analysis results for the metal oxide thin films according to some implementations.
FIG. 27 is a graph showing an example of Spectroscopic ellipsometry (SE) analysis results for the metal oxide thin films according to some implementations.
FIGS. 28 and 29 are graphs showing example results of the photo reliability evaluation for the transistors according to some implementations.
FIG. 30 is a graph showing example electrical characteristic evaluation results for thin films according to some implementations.
FIG. 31 is a graph showing example electrical characteristic evaluation results for transistors according to some implementations.

### DETAILED DESCRIPTION

Hereinafter, example implementations will be explained in detail with reference to the accompanying drawings. It will be understood that, although the terms "first", "second", "third", and so on may be used herein to illustrate various elements, components, regions, layers and/or sections, these elements, components, regions, layers and/or sections should not be limited by these terms. These terms are used to distinguish one element, component, region, layer or section from another element, component, region, layer or section. Accordingly, a first element, component, region, layer or section described under could be termed a second element, component, region, layer or section, without departing from the spirit and scope of the present disclosure.

The terminology used herein is for the purpose of describing some implementations and is not intended to limit the present disclosure. As used herein, the singular forms "a" and "an" are intended to include the plural forms as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. Expression such as "at least one of" when preceding a list of elements may modify the entirety of list of elements and may not modify the individual elements of the list. When referring to "C to D", this means C inclusive to D inclusive unless otherwise specified.

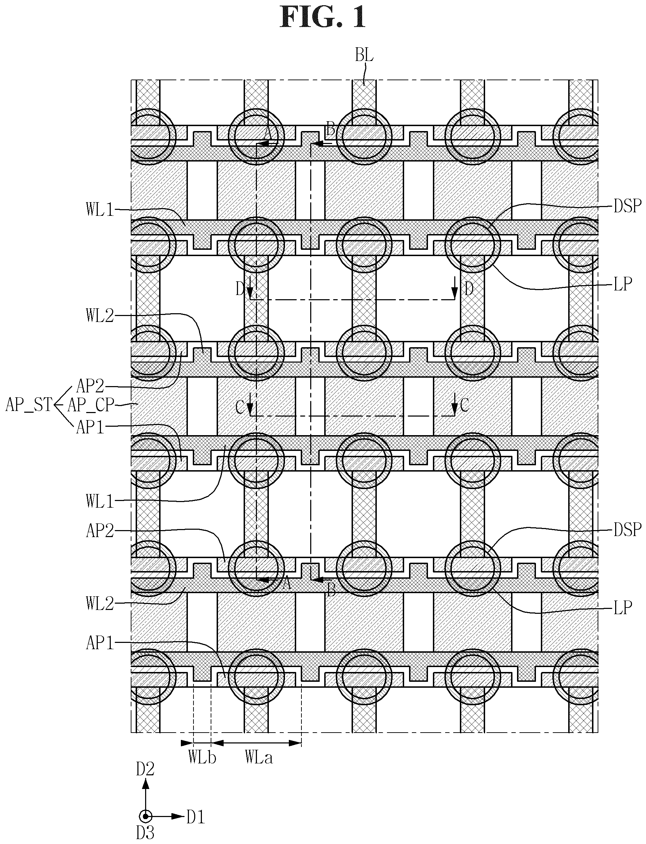

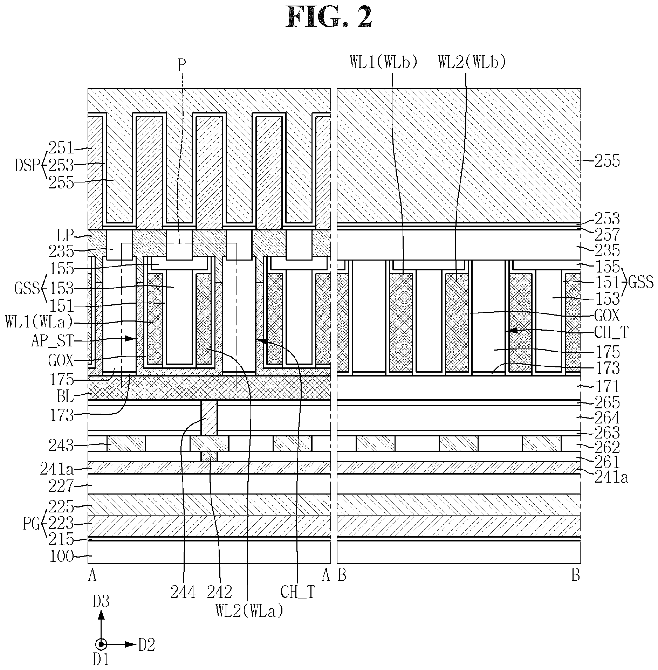

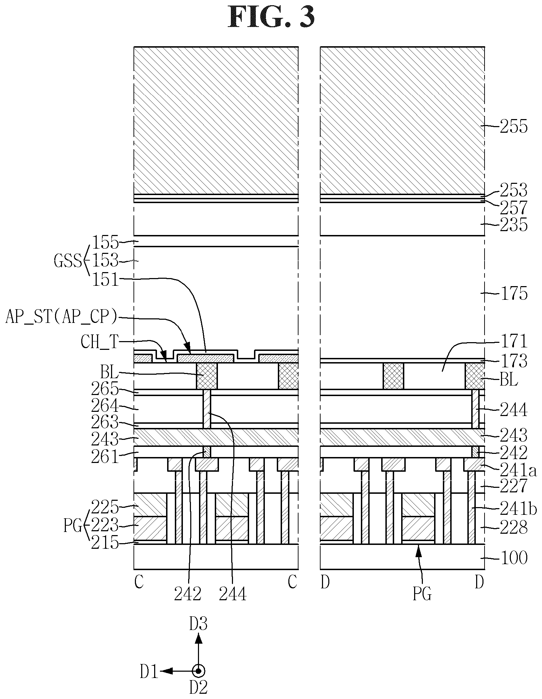

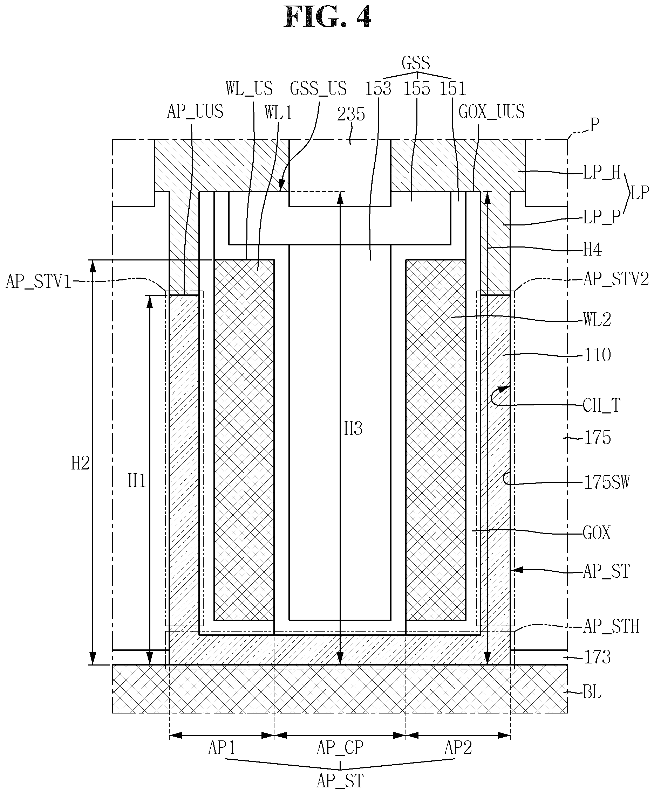

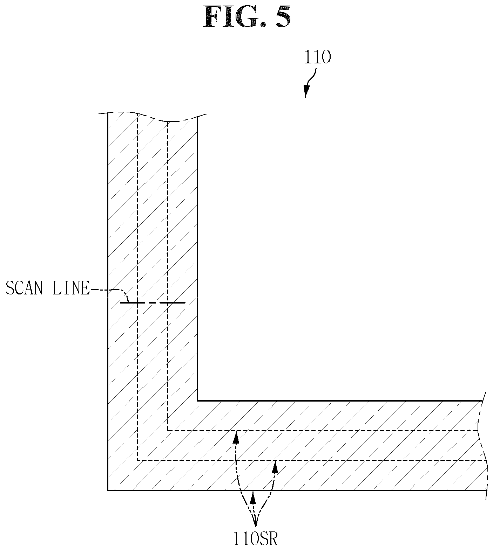

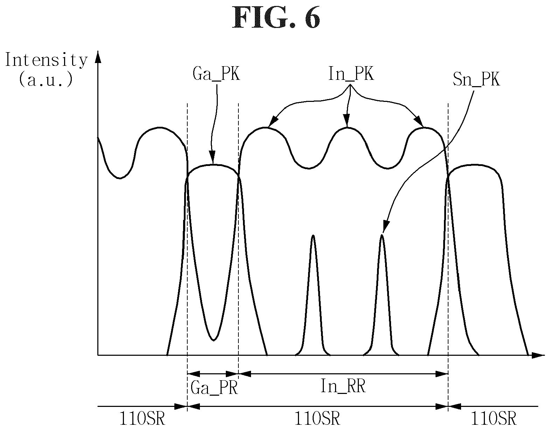

FIG. 1 is a layout view showing an example of a semiconductor memory device according to some implementations. FIG. 2 is a cross-sectional view taken along lines A-A and B-B of FIG. 1 according to some implementations. FIG. 3 is a cross-sectional view taken along lines C-C and D-D of FIG. 1 according to some implementations. FIG. 4 is an enlarged cross-sectional view of an example of a part P of FIG. 2 according to some implementations. FIG. 5 is an enlarged cross-sectional view of an example of a part of a first metal oxide pattern of FIG. 4 according to some implementations. FIG. 6 is a graph showing an example of composition distribution of metals included in the first metal oxide pattern along "SCAN LINE" of FIG. 5 according to some implementations. In some implementations, the semiconductor memory device may include memory cells with vertical channel transistors (VCTs).

In FIGS. 1 to 6, the semiconductor memory device may include a periphery gate structure PG, bitlines BL, wordlines (WL1 and WL2), channel structures AP_ST, protruding insulating patterns 175, and data storage patterns DSP. A substrate 100 may be a silicon substrate or may include other materials, such as silicon germanium, indium antimonide, a lead telluride compound, indium arsenide, indium phosphide, gallium arsenide, or gallium antimonide, but the present disclosure is not limited thereto.

The periphery gate structure PG may be disposed on the substrate 100. The substrate 100 may include a cell array area and a peripheral circuit area. The periphery gate structure PG may be disposed across the cell array area and the peripheral circuit area. In other words, part of the periphery gate structure PG may be disposed in the cell array area of the substrate 100, and the rest of the periphery gate structure PG may be disposed in the peripheral circuit area of the substrate 100.

The periphery gate structure PG may be included in sensing transistors, transfer transistors, and drive transistors. The types of transistors disposed in the cell array area and the peripheral circuit area may vary depending on the design layout of the semiconductor memory device according to some implementations of the present disclosure.

The periphery gate structure PG may include a periphery gate insulating film 215, a periphery lower conductive pattern 223, and a periphery upper conductive pattern 225. The periphery gate insulating film 215 may include a silicon oxide film, a silicon oxynitride film, a high-k insulating film with a greater dielectric constant than silicon oxide, or a combination thereof. The high-k insulating film may include, for example, at least one of a metal oxide, a metal oxynitride, a metal silicon oxide, and a metal silicon oxynitride, but the present disclosure is not limited thereto.

The periphery lower conductive pattern 223 and the periphery upper conductive pattern 225 may include a conductive material. For example, the periphery lower conductive pattern 223 and the periphery upper conductive pattern 225 may include at least one of a doped semiconductor material, a conductive metal nitride, a conductive metal silicon nitride, a metal carbonitride, a conductive metal silicide, a conductive metal oxide, a two-dimensional (2D) material, a metal, and a metal alloy. The periphery gate structure PG is illustrated as including a plurality of conductive patterns, but the present disclosure is not limited thereto.

In the semiconductor memory device, the 2D material may be a metallic material and/or a semiconductor material. The 2D material may include a 2D allotrope or compound, for example, at least one of graphene, molybdenum disulfide (MoS₂), molybdenum diselenide (MoSe₂), tungsten diselenide (WSe₂), and tungsten disulfide (WS₂), but the present disclosure is not limited thereto. That is, the aforementioned examples of the 2D material are merely exemplary and not limiting.

A first periphery lower insulating film 227 and a second periphery lower insulating film 228 are disposed on the substrate 100. The first and second periphery lower insulating films 227 and 228 may be formed of an insulating material.

The second periphery lower insulating film 228 is illustrated as contacting the sidewalls of the periphery lower conductive pattern 223 and the sidewalls of the periphery upper conductive pattern 225, but the present disclosure is not limited thereto. The periphery gate structure PG may include periphery gate spacers, which are disposed on the sidewalls of the periphery lower conductive pattern 223 and the sidewalls of the periphery upper conductive pattern 225.

First periphery wiring lines 241a and periphery contact plugs 241b may be disposed within the first and second periphery lower insulating films 227 and 228. The first periphery wiring lines 241a and the periphery contact plugs 241b are illustrated as belonging to different films, but the present disclosure is not limited thereto. In some implementations, the boundaries between the first periphery wiring lines 241a and the periphery contact plugs 241b may not be distinct. The first periphery wiring lines 241a and the periphery contact plugs 241b may include a conductive material.

A first periphery upper insulating film 261 and a second periphery upper insulating film 262 may be disposed on the first periphery wiring lines 241a and the periphery contact plugs 241b. The first and second periphery upper insulating films 261 and 262 may be formed of an insulating material.

Second periphery wiring lines 243 and periphery via plugs 242 may be disposed on the first periphery wiring lines 241a. The periphery via plugs 242 may be disposed within the first periphery upper insulating film 261. The second periphery wiring lines 243 may be disposed within the second periphery upper insulating film 262.

The second periphery wiring lines 243 and the periphery via plugs 242 may be connected to the first periphery wiring lines 241a. The periphery via plugs 242 may connect the first periphery wiring lines 241a and the second periphery wiring lines 243. The second periphery wiring lines 243 and the periphery via plugs 242 may include a conductive material. The second periphery wiring lines 243 and the periphery via plugs 242 are illustrated as belonging to different films, but the present disclosure is not limited thereto. In some implementations, the boundaries between the second periphery wiring lines 243 and the periphery via plugs 242 may not be distinct.

A third periphery upper insulating film 263, a fourth periphery upper insulating film 264 and a fifth periphery upper insulating film 265 may be sequentially arranged on the second periphery wiring lines 243. The third, fourth, and fifth periphery upper insulating films 263, 264, and 265 may be formed of an insulating material.

The fourth periphery upper insulating film 264 may be formed of a different insulating material from the third and fifth periphery upper insulating films 263 and 265. For example, the fourth periphery upper insulating film 264 may be formed of an oxide-based insulating material, and the third and fifth periphery upper insulating films 263 and 265 may be formed of a nitride-based insulating material. However, the present disclosure is not limited thereto.

Cell connection plugs 244 may be disposed within the third, fourth, and fifth periphery upper insulating films 263, 264, and 265. The cell connection plugs 244 may be connected to the second periphery wiring lines 243. The cell connection plugs 244 may include a conductive material. In some implementations, the cell connection plugs 244 may be disposed within a single periphery upper insulating film. That is, the third, fourth, and fifth periphery upper insulating films 263, 264, and 265 may be integrally formed as a single insulating film.

The bitlines BL may be disposed on the periphery gate structure PG. Specifically, the bitlines BL may be disposed on the fifth periphery upper insulating film 265. For example, the bitlines BL may contact the fifth periphery upper insulating film 265.

The bitlines BL may extend longitudinally in a second direction D2. Each pair of adjacent bitlines BL may be spaced apart from each other in a first direction D1. Each of the bitlines BL include long sidewalls extending in the second direction D2 and short sidewalls extending in the first direction D1.

Each of the bitlines BL may extend from the cell array area to the peripheral circuit area. The ends of each of the bitlines BL may be disposed on the peripheral circuit area of the substrate 100.

The bitlines BL may be disposed on the cell connection plugs 244. The bitlines BL may be connected to the cell connection plugs 244. The bitlines BL may include, for example, at least one of a doped semiconductor material, a conductive metal nitride, a conductive metal silicon nitride, a metal carbonitride, a conductive metal silicide, a conductive metal oxide, a 2D material, a metal, and a metal alloy. The bitlines BL are illustrated as being single films, but the present disclosure is not limited thereto.

A cell lower insulating film 171 may be disposed on the fifth periphery upper insulating film 265. The cell lower insulating film 171 is disposed between the bitlines BL that are spaced apart from one another in the first direction D 1. The cell lower insulating film 171 may be formed of an insulating material.

The protruding insulating patterns 175 may be disposed on the bitlines BL and the cell lower insulating film 171. A cell lower etch stop film 173 may be disposed between the protruding insulating patterns 175 and the cell lower insulating film 171.

The protruding insulating patterns 175 and the cell lower etch stop film 173 may include an insulating material. The cell lower etch stop film 173 may include a material with an etching selectivity to the protruding insulating patterns 175. For example, the protruding insulating patterns 175 may be formed of an oxide-based insulating material containing silicon, but the present disclosure is not limited thereto. For example, the protruding insulating patterns 175 may include silicon oxide.

In some implementations, the cell lower etch stop film 173 may not be disposed between the protruding insulating patterns 175 and the cell lower insulating film 171. In some implementations, each of the protruding insulating patterns 175 may include a plurality of insulating layers that are stacked in a third direction D3. For example, each of the protruding insulating patterns 175 may include a silicon oxide film and a silicon nitride film that are stacked in the third direction D3.

The protruding insulating patterns 175 may include a plurality of channel trenches CH_T. The channel trenches CH_T may extend long in the first direction D1. Each pair of adjacent channel trenches CH_T may be spaced apart from each other in the second direction D2.

The channel trenches CH_T may intersect the bitlines BL. A single channel trench CH_T may expose multiple bitlines BL that are adjacent to one another in the first direction D1.

The bottom surfaces of the channel trenches CH_T may be defined by the bitlines BL and the cell lower insulating film 171. The sidewalls of each of the channel trenches CH_T may be defined by the protruding insulating patterns 175 and the cell lower etch stop film 173. At least parts of the sidewalls of each of the channel trenches CH_T may be sidewalls 175SW of each of the protruding insulating patterns 175. If the cell lower etch stop film 173 is not provided, the sidewalls of each of the channel trenches CH_T may be defined by the protruding insulating patterns 175.

The channel structures AP_ST may be disposed on the bitlines BL. Multiple channel structures AP_ST may be connected to a single bitline BL. Multiple channel structures AP_ST disposed on a single bitline BL are spaced apart from each other in the second direction D2.

The channel structures AP_ST may be disposed within the channel trenches CH_T, which extend in the first direction D1. Multiple channel structures AP_ST may be disposed within a single channel trench CH_T. The channel structures AP_ST, which are disposed within the channel trenches CH_T, are spaced apart in the first direction D1.

For example, the channel structures AP_ST may be arranged two-dimensionally along the first and second directions D1 and D2, which intersect each other.

The channel structures AP_ST may extend along the sidewalls and bottom surfaces of the channel trenches CH_T. The channel structures AP_ST may have a "U" shape in a cross-sectional view taken along the second direction D2.

The channel structures AP_ST may include horizontal portions AP_STH, first vertical portions AP_STV1, and second vertical portions AP_STV2. The first vertical portions AP_STV1 and the second vertical portions AP_STV2 of the channel structures AP_ST may protrude in the third direction D3 from the horizontal portions AP_STH of the channel structures AP_ST.

The horizontal portions AP_STH of the channel structures AP_ST may extend along the bottom surfaces of the channel trenches CH_T. In a cross-section taken along the second direction D2, the horizontal portions AP_STH of the channel structures AP_ST may extend along the upper surfaces of the bitlines BL. The horizontal portions AP_STH of the channel structures AP_ST are connected to the bitlines BL. For example, the horizontal portions AP_STH of the channel structures AP_ST may contact the upper surfaces of the bitlines BL.

The first vertical portions AP_STV1 and the second vertical portions AP_STV2 of the channel structures AP_ST may extend along the sidewalls of the channel trenches CH_T. In a cross-section taken along the second direction D2, the first vertical portions AP_STV1 and the second vertical portions AP_STV2 of the channel structures AP_ST may extend along the sidewalls 175SW of the protruding insulating patterns 175.

The channel structures AP_ST may include first channel patterns AP1, second channel patterns AP2, and connecting channel patterns AP_CP. The connecting channel patterns AP_CP connect the first channel patterns AP1 and the second channel patterns AP2. The first channel patterns AP1 and the second channel patterns AP2 are spaced apart from one another in the second direction D2.

The first channel patterns AP1, the second channel patterns AP2, and the connecting channel patterns AP_CP may be disposed on the bitlines BL. The first channel patterns AP1 and the second channel patterns AP2 are connected to the bitlines BL. The first channel patterns AP1 and the second channel patterns AP2 may contact the upper surfaces of the bitlines BL.

The first channel patterns AP1 may include the first vertical portions AP_STV1 of the channel structures AP_ST and parts of the horizontal portions AP_STH of the channel structures AP_ST. Parts of the horizontal portions AP_STH of the channel structures AP_ST may be the horizontal portions of the first channel patterns AP1. The first vertical portions AP_STV1 of the channel structures AP_ST may be the vertical portions of the first channel patterns AP1.

The second channel patterns AP2 may include the second vertical portions AP_STV2 of the channel structures AP_ST and other parts of the horizontal portions AP_STH of the channel structures AP_ST. The other parts of the horizontal portions AP_STH of the channel structures AP_ST may be the horizontal portions of the second channel patterns AP2. The second vertical portions AP_STV2 of the channel structures AP_ST may be the vertical portions of the second channel patterns AP2.

The connecting channel patterns AP_CP include parts of the horizontal portions AP_STH of the channel structures AP_ST.

The first channel patterns AP1, the second channel patterns AP2, and the connecting channel patterns AP_CP may be distinguished from one another by first wordlines WL1 and second wordlines WL2, which are explained below. Specifically, in FIG. 4, the first wordlines WL1 may include inner sidewalls, which face the sidewalls 175SW of the protruding insulating patterns 175, and outer sidewalls, which are opposite to the inner sidewalls in the second direction D2. The boundaries between the first channel patterns AP1 and the connecting channel patterns AP_CP may be extensions of the outer sidewalls of the first wordlines WL1 that extend in the third direction D3.

The channel structures AP_ST may include an oxide semiconductor material. For example, the channel structures AP_ST may include first metal oxide patterns 110, which are disposed on the bitlines BL.

The first metal oxide patterns 110 may extend along the bottom surfaces and sidewalls of the channel trenches CH_T. The first metal oxide patterns 110 may contact the bitlines BL.

The first metal oxide patterns 110 may include a metal oxide. The first metal oxide patterns 110 may include an oxide semiconductor material containing indium (In), gallium (Ga), and tin (Sn). For example, the first metal oxide patterns 110 may include indium tin gallium oxide (ITGO).

The first metal oxide patterns 110 may include a plurality of oxide semiconductor regions 110SR. The oxide semiconductor regions 110SR may extend along the bottom surfaces and sidewalls of the channel trenches CH_T.

The oxide semiconductor regions 110SR may include an oxide semiconductor material containing In, Ga, and Sn. The oxide semiconductor regions 110SR, which extend along the bottom surfaces and sidewalls of the channel trenches CH_T, may be stacked to form the first metal oxide patterns 110. Each of the first metal oxide patterns 110 is illustrated as having three oxide semiconductor regions 110SR stacked, but the present disclosure is not limited thereto.

FIG. 6 shows an example of a composition distribution of the first metal oxide patterns 110. In, FIG. 6 shows the composition distribution of metal components in one oxide semiconductor region 110SR.

In FIG. 6, the positions of In peaks In_PK may differ from the positions of Ga peaks Ga_PK. Within one oxide semiconductor region 110SR, the number of In peaks In_PK may differ from the number of Ga peaks Ga_PK. For example, the number of In peaks In_PK may be greater than the number of Ga peaks Ga_PK.

Within one oxide semiconductor region 110SR, a plurality of In peaks In_PK may appear. In one oxide semiconductor region 110SR, one Ga peak Ga_PK may appear. Sn peaks Sn_PK may appear between the In peaks In_PK. In some implementations, one oxide semiconductor region 110SR may include multiple In peaks In_PK and one Ga peak Ga_PK. In the composition distribution of the first metal oxide patterns 110, the ratio of the number of In peaks In_PK to the number of Ga peaks Ga_PK may be 2 or greater.

Since the numbers of In peaks In_PK and Ga peaks Ga_PK appearing in one oxide semiconductor region 110SR vary, the number of In peaks In_PK may differ from the number of Ga peaks Ga_PK in the composition distribution of the first metal oxide patterns 110. For example, the number of In peaks In_PK may be greater than the number of Ga peaks Ga_PK.

In other words, the first metal oxide patterns 110 may include In-rich areas In_RR and Ga-rich areas Ga_RR. Each of the oxide semiconductor regions 110SR may include an In-rich area In_RR and a Ga-rich area Ga_RR. The In-rich areas In_RR and the Ga-rich areas Ga_RR may extend along the sidewalls and bottom surfaces of the channel trenches CH_T.

Since the Sn peaks Sn_PK may appear between the In peaks In_PK, the In-rich areas In_RR include Sn. Multiple In peaks In_PK may appear in each of the In-rich areas In_RR. Each of the In-rich areas In_RR may include multiple In peaks In_PK.

For example, the Ga-rich areas Ga_RR may be areas containing more Ga than In and Sn. The Ga-rich areas Ga_RR may include Ga peaks Ga_PK.

For example, the content of Sn included in the first metal oxide patterns 110 may be less than the content of In included in the first metal oxide patterns 110. Additionally, the content of In in the first metal oxide patterns 110 may be greater than the sum of the contents of Sn and Ga included in the first metal oxide patterns 110.

The ratio of Sn to all the metal elements included in the first metal oxide patterns 110, i.e., Sn/(In+Sn+Ga), may be, for example, between 10 (atomic percent, at%) and 30 at%. The ratio of Sn included in the first metal oxide patterns 110 will be detailed later in further detail.

The Sn peaks Sn_PK are illustrated as being lower than the In peaks In_PK and the Ga peaks Ga_PK, but the present disclosure is not limited thereto.

In the semiconductor memory device, the first channel patterns AP1, the second channel patterns AP2, and the connecting channel patterns AP_CP may include the first metal oxide patterns 110.

In a case where the first metal oxide patterns 110 are formed by, for example, a physical vapor deposition (PVD) method using a target and containing ITGO, In, Ga, and Sn may be uniformly distributed throughout the first metal oxide patterns 110. Furthermore, the composition ratio of In, Ga, and Sn included in a deposited ITGO film may be determined based on the ratio of In, Ga, and Sn contained in the target. That is, to change the composition ratio of In, Ga, and Sb in the ITGO film, the target used in the PVD method needs to be changed.

In the semiconductor memory device, indium oxide, tin oxide, and gallium oxide may be formed by an atomic layer deposition (ALD) method to produce an ITGO film. In this case, the positions of the In peaks In_PK may differ from the positions of the Ga peaks Ga_PK. Additionally, the Sn peaks Sn_PK may be positioned between adjacent In peaks In_PK. The composition ratio of In, Ga, and Sn in the deposited ITGO film can be easily controlled by adjusting the number of deposition cycles for forming indium oxide, tin oxide, and gallium oxide.

In FIGS. 2 and 3, memory cells including the channel structures AP_ST are disposed on the periphery gate structure PG, but the present disclosure is not limited thereto. In some implementations, memory cells including the channel structures AP_ST may be spaced apart from the periphery gate structure PG in a horizontal direction (i.e., the first direction D1 and/or the second direction D2), rather than in a vertical direction (i.e., the third direction D3).

The first wordlines WL1 and the second wordlines WL2 may be disposed on the channel structures AP_ST. The first wordlines WL1 and the second wordlines WL2 may be disposed within the channel trenches CH_T.

The first wordlines WL1 and the second wordlines WL2 may extend in the first direction D1. The first wordlines WL1 and second wordlines WL2 may be alternately arranged in the second direction D2. The first wordlines WL1 are spaced apart from the second wordlines WL2 in the second direction D2.

The first wordlines WL1 and the second wordlines WL2 are spaced apart from the bitlines BL in the third direction D3. The first wordlines WL1 and the second wordlines WL2 intersect the bitlines BL.

The first wordlines WL1 and the second wordlines WL2 may be disposed on the horizontal portions AP_STH of the channel structures AP_ST. The first wordlines WL1 and the second wordlines WL2 are disposed between the first vertical portions AP_STV1 and the second vertical portions AP_STV2 of the channel structures AP_ST.

The first wordlines WL1 are disposed on the first channel patterns AP1. The second wordlines WL2 are disposed on the second channel patterns AP2. The first wordlines WL1 and the second wordlines WL2 are disposed between the first channel patterns AP1 and the second channel patterns AP2. The first channel patterns AP1 are closer to the first wordlines WL1 than to the second wordlines WL2. The second channel patterns AP2 are closer to the second wordlines WL2 than to the first wordlines WL1.

The first wordlines WL1 and the second wordlines WL2 may have a width in the second direction D2. The width of portions of the first wordlines WL1 that overlap with the channel structures AP_ST in the third direction D3 may differ from the width of portions of the first wordlines WL that do not overlap with the channel structures AP_ST. Similarly, the width of portions of the second wordlines WL2 that overlap with the channel structures AP_ST in the third direction D3 may differ from the width of portions of the second wordlines WL2 that do not overlap with the channel structures AP_ST.

For example, each of the first wordlines WL1 and second wordlines WL2 may include first portions WLa and second portions WLb. The width, in the second direction D2, of the first portions WLa of the wordlines may be smaller than the width, in the second direction D2, of the second portions WLb of the wordlines. As an example, the first portions WLa of the wordlines may be disposed on the channel structures AP_ST. The first portions WLa of the wordlines may be disposed on the first channel patterns AP1 and the second channel patterns AP2.

Each of the first wordlines WL1 and second wordlines WL2 may include first portions WLa and second portions WLb that are alternately arranged along the first direction D1. The channel structures AP_ST may be disposed between a pair of adjacent second portions WLb of the wordlines in the first direction D1. In each of the first wordlines WL1, each of the first channel patterns AP1 may be disposed between a pair of adjacent second portions WLb of the first wordlines WL1 in the first direction D1. In each of the second wordlines WL2, each of the second channel patterns AP2 may be disposed between a pair of adjacent second portions WLb of the second wordlines WL2 in the first direction D1.

The channel structures AP_ST are not disposed below the second portions WLb of the wordlines. The height of the first portions WLa of the wordlines may be smaller than the height of the second portions WLb of the wordlines. For example, the difference between the height of the first portions WLa of the wordlines and the height of the second portions WLb of the wordlines may be the same as the thickness of the channel structures AP_ST.

The first wordlines WL1 and the second wordlines WL2 may include a conductive material, for example, at least one of a doped polysilicon, a conductive metal nitride, a conductive metal silicon nitride, a metal carbonitride, a conductive metal silicide, a conductive metal oxide, a 2D material, a metal, and a metal alloy.

Each of the first wordlines WL1 and second wordlines WL2 may include an upper surface WL_US and a bottom surface that are opposite to each other in the third direction D3. The bottom surfaces of the first wordlines WL1 and second wordlines WL2 face the bitlines BL. For example, the upper surfaces WL_US of the first wordlines WL1 and second wordlines WL2 may be flat.

Based on the upper surfaces of the bitlines BL, the upper surfaces WL_US of the first wordlines WL1 and second wordlines WL2 may be higher than uppermost parts AP_UUS of vertical portions (AP_STV1 and AP_STV2) of the channel structures AP_ST. The uppermost parts of the first channel patterns AP1 and second channel patterns AP2 may be the uppermost parts AP_UUS of the vertical portions (AP_STV1 and AP_STV2) of the channel structures AP_ST. For example, the uppermost parts AP_UUS of the vertical portions (AP_STV1 and AP_STV2) of the channel structures AP_ST may include the first metal oxide patterns 110. A height H1 from the upper surfaces of the bitlines BL to the uppermost parts AP_UUS of the vertical portions (AP_STV1 and AP_STV2) of the channel structures AP_ST may be less than a height H2 from the upper surfaces of the bitlines BL to the upper surfaces WL_US of the first wordlines WL1 and the second wordlines WL2.

A gate insulating film GOX may be disposed between the first wordlines WL1 and the channel structures AP_ST, and between the second wordlines WL2 and the channel structures AP_ST. The gate insulating film GOX may be disposed between the first wordlines WL1 and the first channel patterns AP1, and between the second wordlines WL2 and the second channel patterns AP2. The gate insulating film GOX may extend in the first direction D1 in parallel to the first wordlines WL1 and the second wordlines WL2.

The gate insulating film GOX may extend along the first vertical portions AP_STV1 of the channel structures AP_ST. The gate insulating film GOX may extend along the second vertical portions AP_STV2 of the channel structure AP_ST. In the semiconductor memory device, the gate insulating film GOX may not be disposed on the horizontal portions AP_STH of the channel structures AP_ST that do not overlap in the third direction D3 with the first wordlines WL1 and the second wordlines WL2. From a cross-sectional perspective, parts of the gate insulating film GOX between the first wordlines WL1 and the channel structures AP_ST may be separate from parts of the gate insulating film GOX between the second wordlines WL2 and the channel structures AP ST.

The gate insulating film GOX may include silicon oxide, silicon oxynitride, a high-k insulating film with a greater dielectric constant than silicon oxide, or a combination thereof.

Parts of the gate insulating film GOX may protrude in the third direction D3 beyond the upper surfaces WL_US of the first wordlines WL1 and second wordlines WL2. Parts of the gate insulating film GOX may also protrude in the third direction D3 beyond the uppermost parts AP_UUS of the vertical portions (AP_STV1 and AP_STV2) of the channel structures AP_ST.

A height H4 from the upper surfaces of the bitlines BL to uppermost parts GOX_UUS of the gate insulating film GOX may be greater than the height H1 from the upper surfaces of the bitlines BL to the uppermost parts AP_UUS of the vertical portions (AP_STV1 and AP_STV2) of the channel structures AP_ST. The height H4 from the upper surfaces of the bitlines BL to the uppermost parts GOX_UUS of the gate insulating film GOX may also be greater than the height H2 from the upper surfaces of the bitlines BL to the upper surfaces WL_US of the wordlines (WL1 and WL2).

Gate separation patterns GSS may be disposed on the bitlines BL and the cell lower insulating film 171. The gate separation patterns GSS may be disposed within the channel trenches CH_T. The gate separation patterns GSS may be disposed on the channel structures AP_ST, the first wordlines WL1, and the second wordlines WL2.

In the semiconductor memory device, the gate separation patterns GSS may contact the channel structures AP_ST. The gate separation structures GSS may be disposed on the connecting channel patterns AP_CP. The gate separation structures GSS may contact the horizontal portions AP_STH of the channel structures AP_ST. The gate separation patterns GSS may be spaced apart from the bitlines BL in the third direction D3.

Each of the gate separation patterns GSS may be disposed between a pair of adjacent first and second wordlines WL1 and WL2 in the second direction D2. The first wordlines WL1 and the second wordlines WL2 may be separated by the gate separation pattern GSS. The first gate separation patterns GSS may extend in the first direction D1 between the first wordlines WL1 and the second wordlines WL2.

The first wordlines WL1 may be disposed between the gate separation patterns GSS and the channel structures AP_ST. Similarly, the second wordlines WL2 may be disposed between the gate separation patterns GSS and the channel structures AP_ST. The first wordlines WL1 may be disposed between the gate separation patterns GSS and the first channel patterns AP1. The second wordlines WL2 may be disposed between the gate separation patterns GSS and the second channel patterns AP2.

The gate separation patterns GSS may include horizontal portions and protruding portions. The protruding portions of the gate separation patterns GSS may protrude from the horizontal portions of the gate separation patterns GSS toward the bitlines BL in the third direction D3. The protruding portions of the gate separation patterns GSS may be closer than the horizontal portions of the gate separation patterns GSS to the bitlines BL. The horizontal portions of the gate separation patterns GSS may be disposed on the upper surfaces WL_US of the first wordlines WL1 and second wordlines WL2. In a cross-sectional view, the gate separation patterns GSS may have a "T" shape.

The gate separation patterns GSS may include gate separation liners 151, gate separation filling films 153, and gate separation capping films 155. The gate separation liners 151 may extend along the upper surfaces WL_US and the outer walls of the first wordlines WL1 and second wordlines WL2. The gate separation liners 151 may also extend along the horizontal portions AP_STH of the channel structures AP_ST. The gate separation liners 151 may contact the connecting channel patterns AP_CP. The gate separation liners 151 may extend along the parts of the gate insulating film GOX that protrude beyond the upper surfaces WL _US of the first wordlines WL1 and second wordlines WL2. The gate separation liners 151 may contact the sidewalls of the gate insulating film GOX. In some implementations, the gate separation liner 151 may not extend along the parts of the gate insulating film GOX that protrude beyond the upper surfaces WL_US of the first wordlines WL1 and second wordlines WL2.

The gate separation filling films 153 may be disposed on the gate separation liners 151. The gate separation capping films 155 may be disposed on the gate separation filling films 153. The gate separation liners 151, the gate separation filling films 153, and the gate separation capping films 155 may be formed of an insulating material. In some implementations, the gate separation patterns GSS may be formed as single films.

Based on the upper surfaces of the bitlines BL, upper surface GSS_US of the gate separation patterns GSS may be at the same height as the upper surfaces of the protruding insulating patterns 175, but the present disclosure is not limited thereto.

A height H3 from the upper surfaces of the bitlines BL to the upper surfaces GSS _US of the gate separation patterns GSS may be greater than the height H1 from the upper surfaces of the bitlines BL to the uppermost parts AP_UUS of the vertical portions (AP_STV1 and AP_STV2) of the channel structures AP_ST. The height H3 from the upper surfaces of the bitlines BL to the upper surfaces GSS_US of the gate separation patterns GSS may also be greater than the height H2 from the upper surfaces of the bitlines BL to the upper surfaces WL_US of the wordlines (WL1 and WL2).

The height H3 from the upper surfaces of the bitlines BL to the upper surfaces GSS_US of the gate separation patterns GSS is illustrated as being the same as the height H4 from the upper surfaces of the bitlines BL to the uppermost parts GOX_UUS of the gate insulating film GOX, but the present disclosure is not limited thereto.

Landing pads LP may be disposed on the channel structures AP_ST. The landing pads LP are connected to the first vertical portions AP_STV1 and the second vertical portions AP_STV2 of the channel structures AP_ST.

The landing pads LP may be disposed on the first channel patterns AP1 and the second channel patterns AP2. The landing pads LP are connected to the first channel patterns AP1 and the second channel patterns AP2.

From a planar perspective, the landing pads LP may have various shapes such as a circular shape, an oval shape, a rectangular shape, a square shape, a diamond shape, a hexagonal shape, etc. From a planar perspective, the landing pads LP may be arranged in a matrix form along the first and second directions D1 and D2.

The landing pads LP may include horizontal portions LP_H and protruding portions LP_P. The horizontal portions LP_H of the landing pads LP may be disposed on the upper surfaces of the protruding insulating patterns 175 and the upper surfaces GSS_US of the gate separation patterns GSS. The protruding portions LP_P of the landing pads LP may protrude from the horizontal portions LP_H of the landing pads LP toward the bitlines BL in the third direction D3.

Based on the upper surfaces of the bitlines BL, lowermost parts of the landing pads LP may be lower than the upper surfaces GSS_US of the gate separation patterns GSS. In other words, the protruding portions LP_P of the landing pads LP are disposed positioned between the protruding insulating patterns 175 and the gate separation patterns GSS. The height from the upper surfaces of the bitlines BL to the lowermost parts of the landing pad LP may be less than the height H4 from the upper surfaces of the bitlines BL to the uppermost parts GOX _UUS of the gate insulating film GOX.

Pad separation insulating patterns 235 may be disposed between the landing pads LP. From a planar perspective, the landing pads LP may be arranged in a matrix form along the first and second directions D1 and D2. The upper surfaces of the landing pads LP may be on the same plane as the upper surfaces of the pad separation insulating patterns 245, but the present disclosure is not limited thereto.

The landing pads LP include a conductive material. For example, the landing pads LP may include at least one of a doped polysilicon, a conductive metal nitride, a conductive metal silicon nitride, a metal carbonitride, a conductive metal silicide, a conductive metal oxide, a 2D material, a metal, and a metal alloy. The pad separation insulating patterns 235 may include a nitride-based insulating material containing silicon, such as silicon nitride, but the present disclosure is not limited thereto.

A cell top etch stop film 257 may be disposed on the landing pads LP and the pad separation insulating patterns 235. The cell top etch stop film 257 may extend along the upper surfaces of the pad separation insulating patterns 235 and parts of the upper surfaces of the landing pads LP.

The cell top etch stop film 257 may include, for example, a nitride-based insulating material containing silicon. The cell top etch stop film 257 may include, for example, at least one of silicon nitride (SiN), silicon carbonitride (SiCN), silicon boron nitride (SiBN), and silicon oxynitride (SiON), but the present disclosure is not limited thereto.

The data storage patterns DSP may be disposed on the landing pads LP, respectively. The data storage patterns DSP may be connected to the first vertical portions AP_STV1 and the second vertical portions AP_STV2 of the channel structures AP_ST. The data storage patterns DSP may be respectively connected to the first channel patterns AP1 and the second channel patterns AP2.

In FIG. 1, the data storage patterns DSP may be arranged in a matrix form along the first and second directions D1 and D2. The data storage patterns DSP may fully or partially overlap with the landing pads LP in the third direction D3. The data storage patterns DSP may contact the entire upper surfaces of the landing pads LP or parts of the upper surfaces of the landing pads LP.

For example, the data storage patterns DSP may be capacitors. The first channel patterns AP1 may be connected to first capacitors. The second channel patterns AP2 may be connected to second capacitors.

The data storage patterns DSP may include storage electrodes 251, a plate electrode 255, and a capacitor dielectric film 253, which is interposed between the storage electrodes 251 and the plate electrode 255. The plate electrode 255 is illustrated as being a single film, but the present disclosure is not limited thereto.

For example, the storage electrodes 251 may contact the landing pads LP. From a planar perspective, the storage electrodes 251 may have various shapes, such as circular shape, an oval shape, a rectangular shape, a square shape, a diamond shape, a hexagonal shape, etc. The data storage patterns DSP may fully or partially overlap with the landing pads LP. The data storage patterns DSP may contact the entire upper surfaces of the landing pads LP or parts of the upper surfaces of the landing pads LP. The storage electrodes 251 may penetrate the cell top etch stop film 257.

The storage electrodes 251 and the plate electrode 255 may include, for example, at least one of a conductive semiconductor material, a conductive metal nitride, a conductive metal silicon nitride, a metal carbonitride, a conductive metal silicide, a conductive metal oxide, and a metal. The capacitor dielectric film 253 may include at least one of a ferroelectric material, an antiferroelectric material, and a paraelectric material. For example, the capacitor dielectric film 253 may include at least one of a ferroelectric material, an antiferroelectric material, and a paraelectric material, a combination of the ferroelectric and antiferroelectric materials, a combination of the ferroelectric and paraelectric materials, a combination of the paraelectric and antiferroelectric materials, and a combination of the ferroelectric, antiferroelectric, and paraelectric materials.

Conversely, the data storage patterns DSP may be variable resistance patterns that may be switched between two resistance states by electrical pulses applied to memory elements. For example, the data storage patterns DSP may include a phase-change material whose crystalline state changes with the amount of current, a perovskite compound, a transition metal oxide, a magnetic material, a ferromagnetic material, or an antiferromagnetic material.

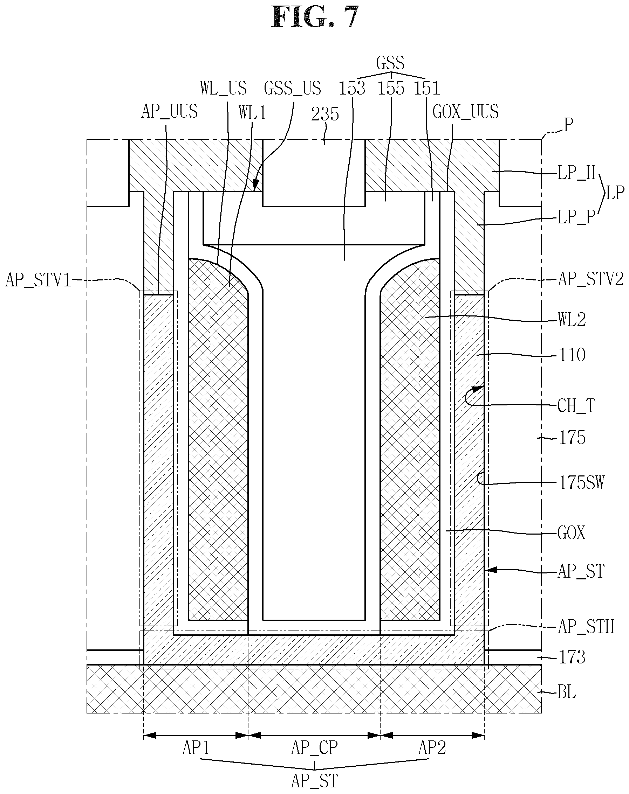

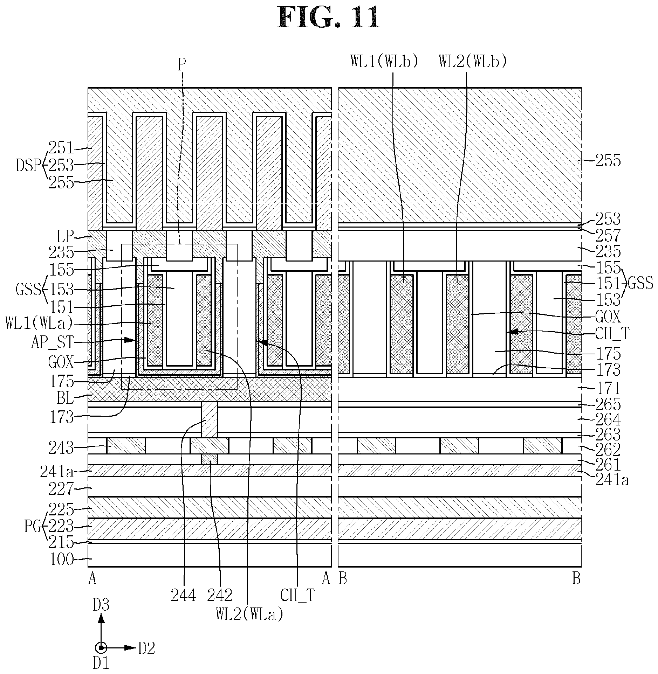

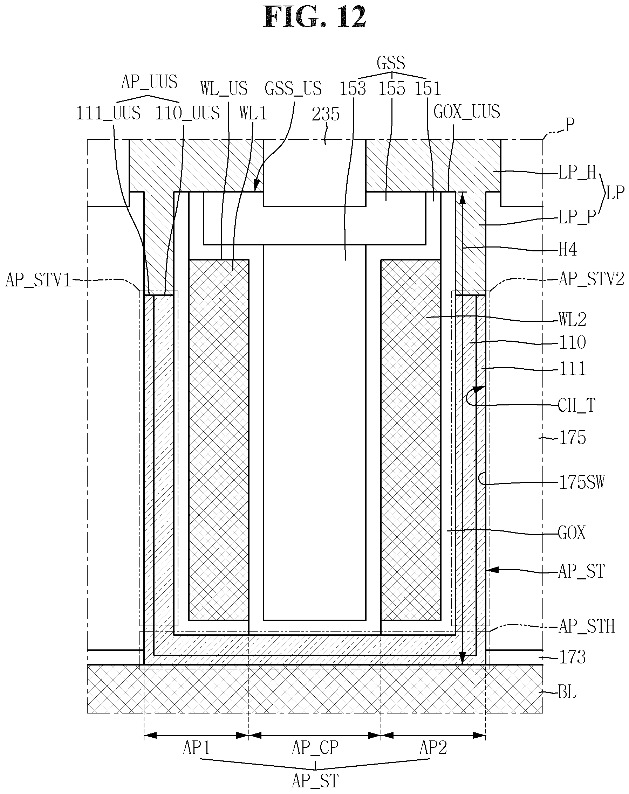

FIGS. 7 to 10 are diagrams showing an example of a semiconductor memory devices according to some implementations. FIGS. 11 and 12 are diagrams showing an example of a semiconductor memory device according to some implementations. For convenience, FIGS. 7 to 12 will be described, focusing mainly on the differences from FIGS. 1 to 6. FIG. 12 is an enlarged cross-sectional view of an example of a part P of FIG. 11 according to some implementations.

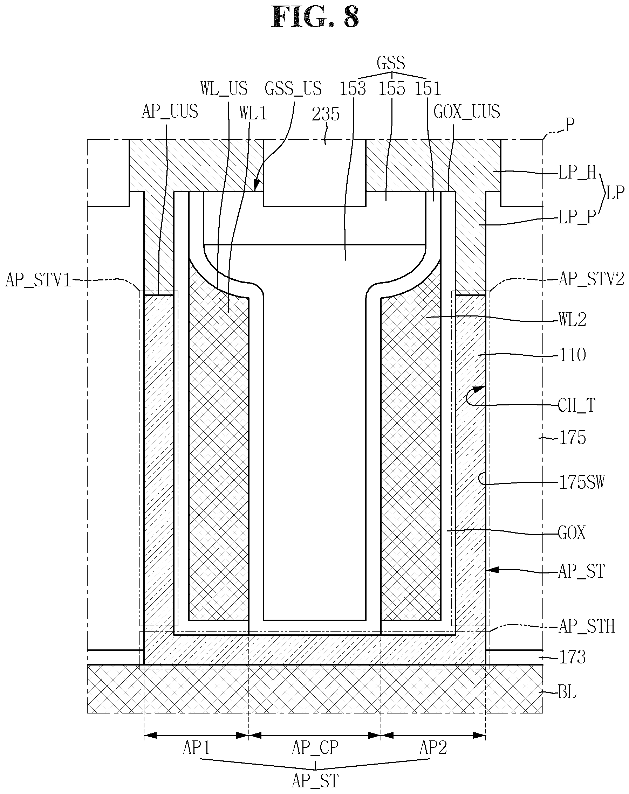

In FIGS. 7 and 8, upper surfaces WL_US of first and second wordlines WL1 and WL2 may include curved surfaces. The upper surfaces WL_US of the first and second wordlines WL1 and WL2 may be convexly rounded.

In FIG. 8, the upper surfaces WL_US of the first and second wordlines WL1 and WL2 may be concavely rounded.

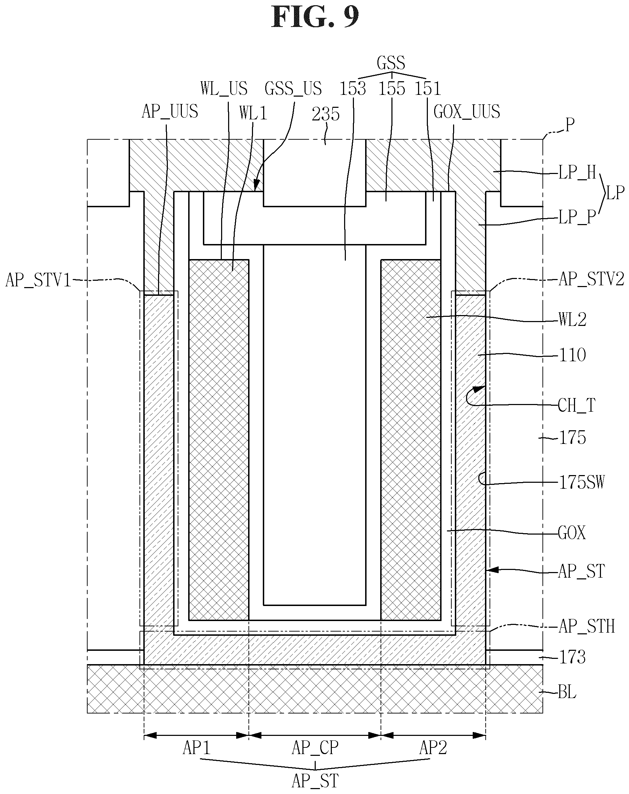

In FIG. 9, a gate separation pattern GSS does not contact a channel structure AP_ST.

Part of a gate insulating film GOX may be disposed between the gate separation pattern GSS and the channel structure AP_ST. From a cross-sectional perspective, part of the gate insulating film GOX between a first wordline WL1 and the channel structure AP_ST may be connected to part of the gate insulating film GOX between a second wordline WL2 and the channel structure AP_ST.

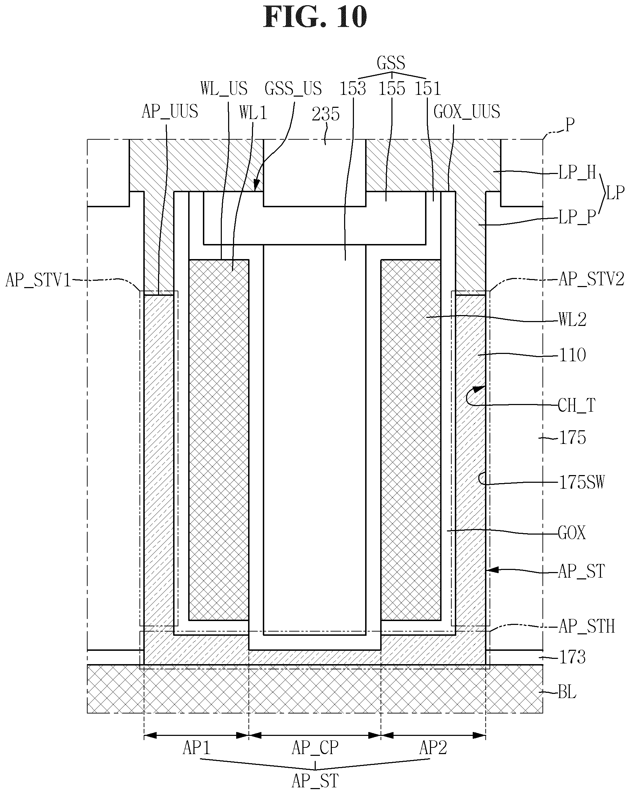

In FIG. 10, part of a gate separation pattern GSS may be indented into a channel structure AP_ST. The thickness of a connecting channel patterns AP_CP is less than the thickness of a horizontal portion AP_STH of the channel structure AP_ST, which is included in first and second channel patterns AP1 and AP2.

In FIGS. 11 and 12, each of channel structures AP_ST may further include a second metal oxide pattern 111. The second metal oxide pattern 111 may be disposed between a bitline BL and a first metal oxide pattern 110. The second metal oxide pattern 111 may extend along the sidewalls and bottom surface of the channel trench CH_T.

The second metal oxide pattern 111 may include an oxide semiconductor material. For example, the second metal oxide pattern 111 may include a metal oxide. The second metal oxide pattern 111 may include a metal oxide containing In and Sn. The second metal oxide pattern 111 may not include Ga. For example, the second metal oxide pattern 111 may include indium tin oxide (ITO).

Each of the first channel patterns AP1, the second channel patterns AP2, and a connecting channel pattern AP_CP may include the first metal oxide pattern 110 and the second metal oxide pattern 111.

Uppermost parts AP_UUS of vertical portions (AP_STV1 and AP_STV2) of each of the channel structures AP_ST may include an uppermost part 110 _UUS of the first metal oxide pattern 110 and an uppermost part 111_UUS of the second metal oxide pattern 111. The height from the upper surface of the bitline BL to the uppermost part 110 _UUS of the first metal oxide pattern 110 is the same as the height from the upper surface of the bitline BL to the uppermost part 111_UUS of the second metal oxide pattern 111, but the present disclosure is not limited thereto.

Conversely, for example, based on the upper surface of the bitline BL, the uppermost part 110_UUS of the first metal oxide pattern 110 may be lower than the uppermost part 111_UUS of the second metal oxide pattern 111. In another example, based on the upper surface of the bitline BL, the uppermost part 110_UUS of the first metal oxide pattern 110 may be higher than the uppermost part 111_UUS of the second metal oxide pattern 111.

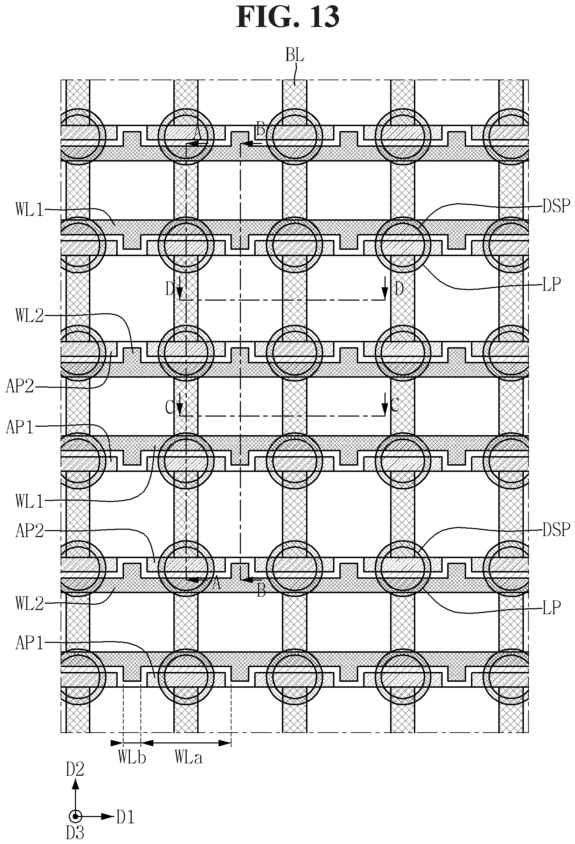

FIGS. 13 to 16 are diagrams showing an example of a semiconductor memory device according to some implementations. For convenience, FIGS. 13 to 16 will be described, focusing mainly on the differences from FIGS. 1 to 6.

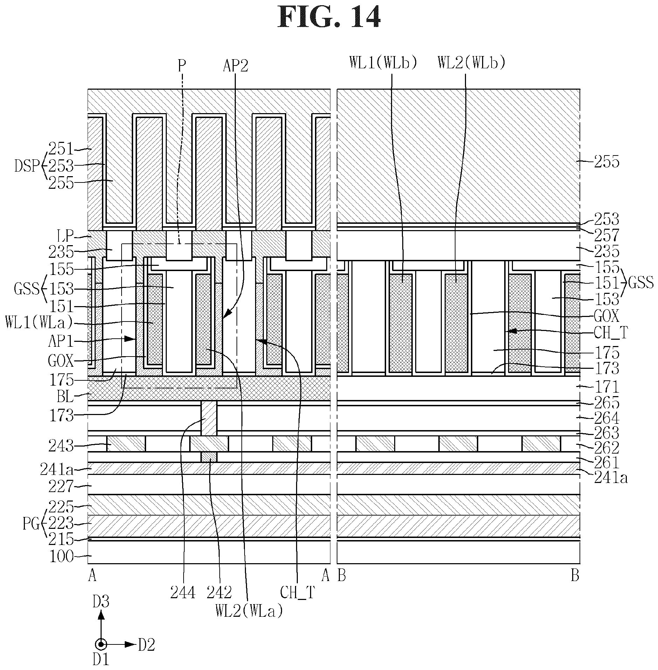

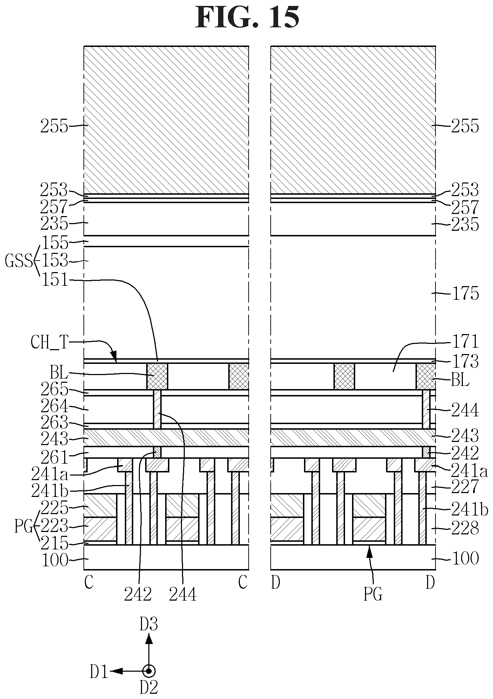

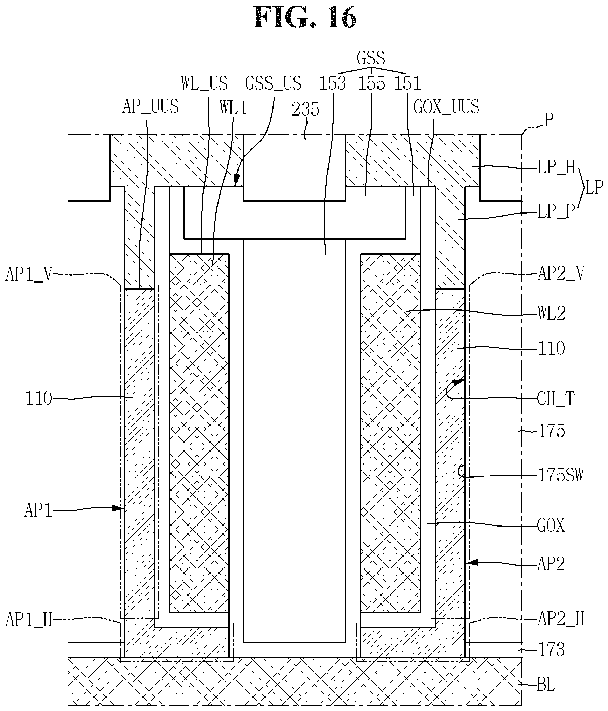

FIG. 13 is a layout view showing an example of a semiconductor memory device according to some implementations. FIG. 14 is a cross-sectional view taken along lines A-A and B-B of FIG. 13. FIG. 15 is a cross-sectional view taken along lines C-C and D-D of FIG. 13. FIG. 16 is an enlarged cross-sectional view of an example of a part P of FIG. 14.

In FIGS. 13 to 16, first channel patterns AP1 and second channel patterns AP2, which are spaced apart from each other in the second direction D2, are not connected within channel trenches CH_T. Each of the first channel patterns AP1 and second channel patterns AP2 may include a first metal oxide pattern 110.

The first channel patterns AP1 may include horizontal portions AP1_H, which extend along the upper surfaces of bitlines BL, and vertical portions AP1_V, which extend along sidewalls 175SW of protruding insulating patterns 175. The vertical portions AP1_V of the first channel patterns AP1 may protrude from the horizontal portions AP1_H of the first channel patterns AP1 in the third direction D3.

The second channel patterns AP2 may include horizontal portions AP2_H, which extend along the upper surfaces of the bitline BL, and vertical portions AP2_V, which extend along the sidewalls 175SW of the protruding insulating patterns 175. The vertical portions AP2_V of the second channel patterns AP2 may protrude from the horizontal portions AP2_H of the second channel patterns AP2 in the third direction D3.

Gate separation patterns GSS may contact the bitlines BL. The horizontal portions AP2_H of the second channel patterns AP2 and the horizontal portions AP1_H of the first channel patterns AP1 may be spatially separated by the gate separation patterns GSS. Gate separation liners 151 may contact the bitlines BL.

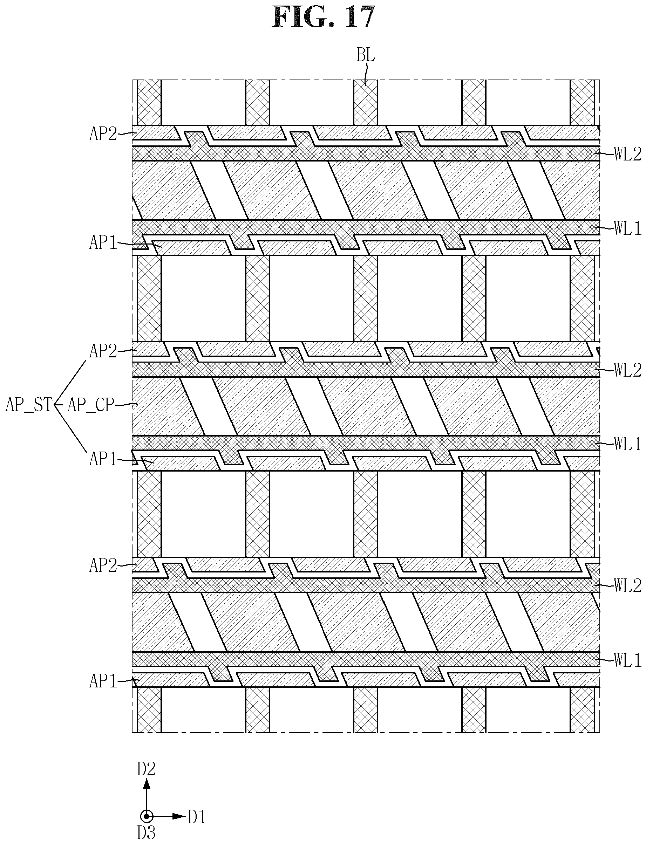

FIGS. 17 to 20 are diagrams showing examples of semiconductor memory devices according to some implementations. For convenience, FIGS. 17 to 20 will be described, focusing mainly on the differences from FIGS. 1 to 6.

In FIG. 17, first channel patterns AP1 and second channel patterns AP2 may be alternately arranged in a diagonal direction relative to first and second directions D1 and D2. Here, the diagonal direction may be parallel to the upper surface of a substrate 100.

Channel structures AP_ST may be formed to be twisted diagonally. From a planar perspective, the first channel patterns AP1, the second channel patterns AP2, and connecting channel patterns AP_CP may have a parallelogram or diamond shape.

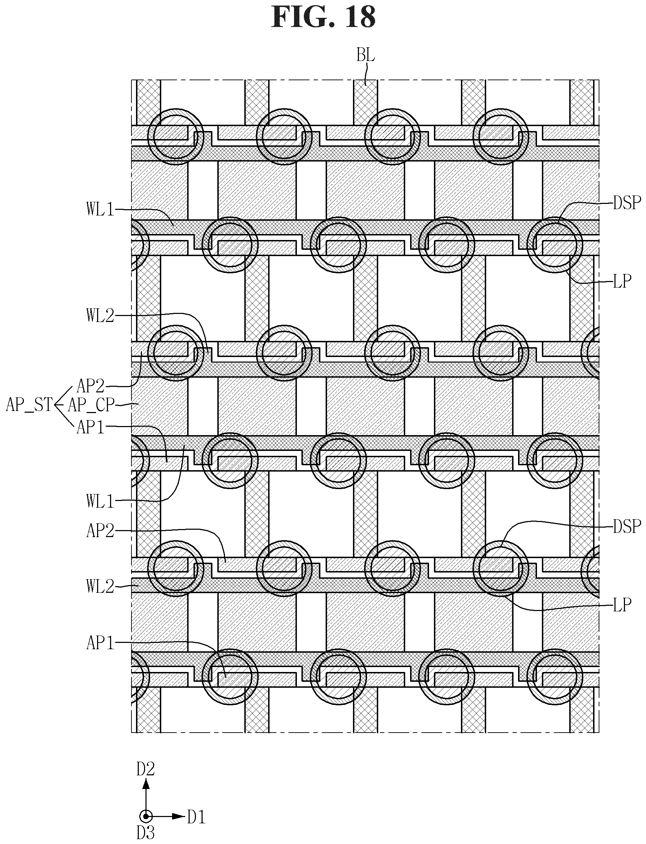

In FIG. 18, from a planar perspective, landing pads LP and data storage patterns DSP may be arranged in a zigzag or honeycomb pattern.

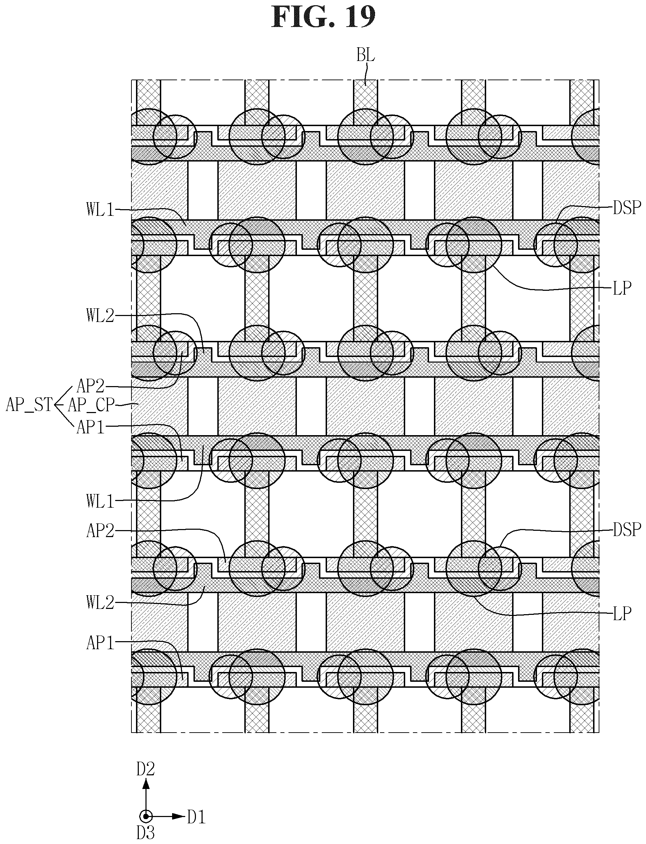

In FIG. 19, from a planar perspective, data storage patterns DSP may be staggered relative to landing pads LP. The data storage patterns DSP may contact parts of the landing pads LP.

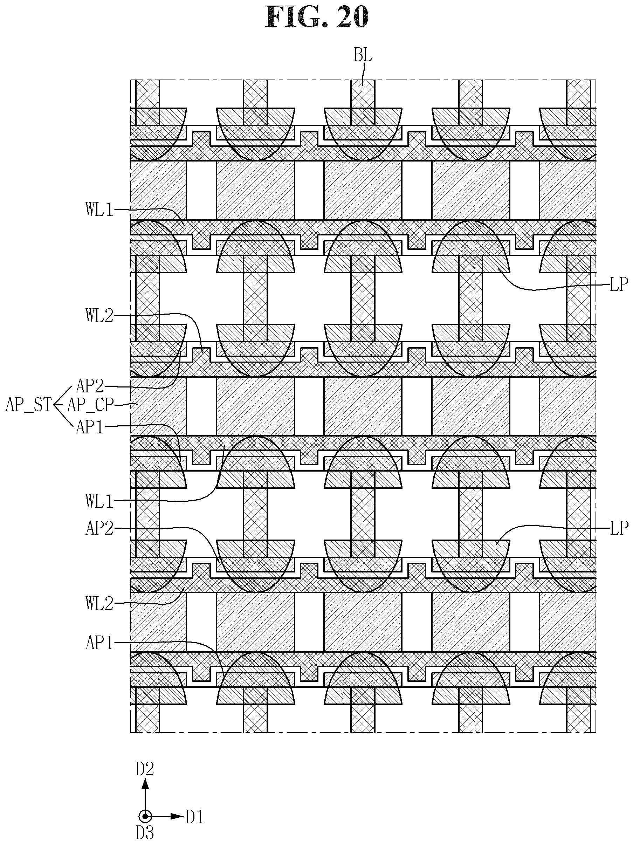

In FIG. 20, from a planar perspective, landing pads LP, which are disposed on first channel patterns AP1 and second channel patterns AP2, may have a semi-circular or semi-elliptical shape. From a planar perspective, the landing pads LP may be arranged symmetrically with respect to one another.

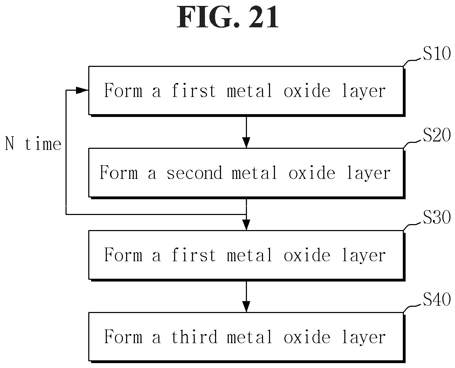

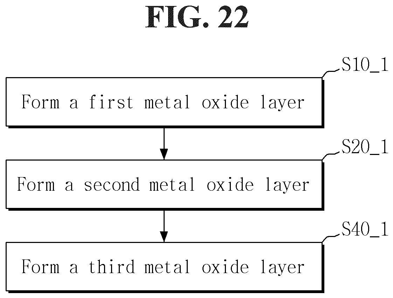

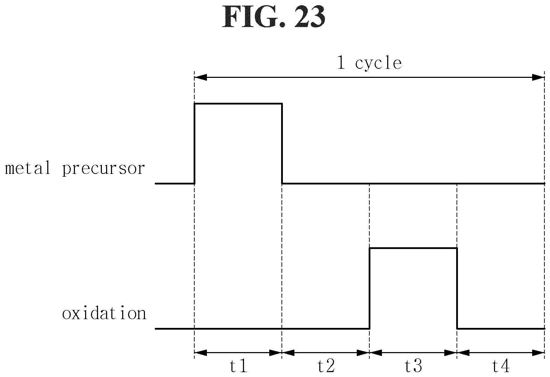

FIG. 21 is a flowchart showing an example of a method of manufacturing a semiconductor memory device according to some implementations. FIG. 22 is a flowchart showing an example of a method of manufacturing a semiconductor memory device according to some implementations. FIG. 23 is a timing diagram showing an example of a deposition cycle for forming each metal oxide film of FIGS. 21 and 22 according to some implementations.

In FIG. 21, a method of manufacturing a semiconductor memory device may include the steps of: forming a first metal oxide film (S10); forming a second metal oxide film (S20); forming an additional first metal oxide film (S30); and forming a third metal oxide film (S40).

The first, second, and third metal oxide films may include, for example, one of indium oxide, tin oxide, and gallium oxide. The first, second, and third metal oxide films include different materials. For example, the first metal oxide film may include indium oxide. For example, the second metal oxide film may include tin oxide. For example, the third metal oxide may include gallium oxide. The first, second, and third metal oxide films may be formed using the ALD method.

Initially, the steps of forming the first metal oxide film and the second metal oxide film, i.e., steps S10 and S20, may be repeated N times. As a result, N first metal oxide films and N second metal oxide films may be alternately formed on a substrate ("100" of FIG. 2).

Thereafter, the step of forming the additional first metal oxide film, i.e., step S30, may be performed. The additional first metal oxide film may be formed on the uppermost second metal oxide film. As a result, a total of (N+1) first metal oxide films and N second metal oxide films may be alternately stacked.

Thereafter, the step of forming the third metal oxide film, i.e., step S40, may be performed. The third metal oxide film may be formed on the first metal oxide films and the second metal oxide films that are alternately stacked.

In this manner, one oxide semiconductor region ("110SR" of FIG. 5) may be formed. By repeating the aforementioned processes, a plurality of oxide semiconductor regions 110SR may be formed.

In FIG. 23, a single deposition cycle for forming a metal oxide film is illustrated, in which the single deposition cycle may include a metal precursor injection stage t1, a first purge stage t2, a metal oxidation stage t3, and a second purge stage t4.

In the metal precursor injection stage t1, a metal precursor may be provided within a reaction chamber. The metal precursor may contain a metal atom that constitutes a first, second, or third metal oxide film. For example, the metal precursor may include one of In, Sn, and Ga.

In the first purge stage t2, a metal precursor not bonded to a target surface where a metal oxide film is to be deposited may be removed. An excess metal precursor may be released from the reaction chamber.

In the metal oxidation stage t3, oxygen is supplied to oxidize the metal precursor, allowing the bonded metal on the target surface to be oxidized and form a metal oxide film on the target surface. The oxygen used to oxidize the metal precursor may be provided through, for example, a plasma process.

In the second purge stage t4, any byproducts produced during the formation of the metal oxide film may be removed. Such byproducts may be released from the reaction chamber.

If the metal precursor is a Sn precursor, a single Sn deposition cycle may be completed by the aforementioned four stages.

After conducting the deposition cycle of FIG. 23 at least once, a first, second, or third metal oxide film of FIG. 21 can be formed. For example, the step of forming a first metal oxide film, i.e., step S10 of FIG. 21, may include the deposition cycle of FIG. 23 at least once. That is, after conducting the deposition cycle of FIG. 23 at least once, a first metal oxide film can be formed on a substrate 100.

The step of forming the second metal oxide film, i.e., step S20 of FIG. 21, may include the deposition cycle of FIG. 23 at least once. Similarly, the step of forming a third metal oxide film, i.e., step S40 of FIG. 23, may include the deposition cycle of FIG. 23 at least once.

After conducting the method of FIG. 21 at least once, a channel structure AP_ST of FIGS. 2 and 3 can be obtained.

In FIG. 22, a method of manufacturing a semiconductor memory device may include the steps of: forming a first metal oxide film (S10_1); forming a second metal oxide film (S20_1); and forming a third metal oxide film (S40_1).

The step of forming the first metal oxide film, i.e., step S10_1, may include the deposition cycle of FIG. 23, at least once. In step S10_1, by conducting the deposition cycle of FIG. 23 at least once, a first metal oxide film may be formed on a substrate 100.

Thereafter, the step of forming the second metal oxide film (S20_1) can also include at least one deposition cycle from FIG. 23. In step S20_1, by performing the deposition cycle at least once, a second metal oxide film may be formed on the first metal oxide film.

Thereafter, the step of forming a third metal oxide film, i.e., step S40_1, may include the deposition cycle of FIG. 23 at least once. In step S40_1, by conducting the deposition cycle of FIG. 23 at least once, a third metal oxide film may be formed on the second metal oxide film.

In an ITGO film produced by the method of FIG. 21 and the deposition cycle of FIG. 23, one oxide semiconductor region ("110SR" of FIG. 5) may include indium oxide films and tin oxide films that are alternately stacked.

Conversely, in an ITGO film produced by the method of FIG. 22 and the deposition cycle of FIG. 23, one oxide semiconductor region may include an indium oxide film, a tin oxide film, and a gallium oxide film that are sequentially stacked.

### Experimental Examples

### Production Examples: Fabrication of ITGO Thin Films

Using the ALD method, oxide semiconductor films containing ITGO were fabricated. Specifically, ITGO were fabricated by conducting an ALD cycle for forming indium oxide, gallium oxide, and tin oxide, as described above with reference to FIGS. 21 and 23.

Using the ALD method, Example 1, Example 2, Example 3, and Example 4 were fabricated. Specifically, Example 1 was fabricated by conducting a Sn deposition cycle once during forming one oxide semiconductor region 110SR illustrated in FIG. 21. Example 2 was fabricated by conducting the Sn deposition cycle twice during forming one oxide semiconductor region 110SR. Example 3 was fabricated by conducting the Sn deposition cycle three times during forming one oxide semiconductor region 110SR. Example 4 was fabricated by conducting the Sn deposition cycle five times during forming one oxide semiconductor region 110SR.

### Comparative Example: Fabrication of indium gallium oxide (IGO) Thin Film

Using the ALD method, an oxide semiconductor film containing IGO was fabricated. Specifically, a comparative example was fabricated using the ALD method. During the fabrication of the comparative example, no Sn deposition cycle was conducted.

### Experimental Example 1: Composition Comparison of Metal Oxide Thin Films

The ratios of elements present in each of the metal oxide thin films according to Examples 1, 2, 3, and 4 and the comparative example were analyzed using Auger electron spectroscopy (AES), and the results are as shown in Table 1 below. Table 1 shows the ratios of metal elements (excluding oxygen) present in each of the ITGO films according to Examples 1, 2, 3, and 4 and the comparative example.

**[Table 1]**

| | In (at%) | Sn (at%) | Ga (at%) | In + Sn + Ga (at%) |
|---|---|---|---|---|
| Comparative Example (C1) | 79.94 | 0 | 20.06 | 100 |
| Example 1 (S1) | 70.32 | 6.18 | 23.5 | 100 |
| Example 2 (S2) | 73 | 12.8 | 14.2 | 100 |
| Example 3 (S3) | 58.35 | 27.12 | 14.53 | 100 |
| Example 4 (S4) | 51.66 | 38.29 | 10.05 | 100 |

Referring to Table 1, when no Sn deposition cycle was conducted (i.e., in the case of the comparative example), the content of Sn was 0 at% in the IGO film according to the comparative example. Additionally, when the Sn deposition cycle was conducted once, twice, three times, and five times (i.e., in the cases of Examples 1, 2, 3, and 4), the content of Sn was 6.18 at%, 12.8 at%, 27.12 at%, and 38.29 at% in the ITGO films according to Examples 1, 2, 3, and 4, respectively.

This demonstrates that during the manufacture of a metal oxide thin film using the ALD method, the content of Sn included in the metal oxide film can be precisely controlled by adjusting the number of Sn deposition cycles.

### Experimental Example 2: Evaluation of Characteristics of Devices Containing Metal Oxide Thin Films

Transistors having, as channel layers, the metal oxide thin films according to Examples 1, 2, 3, and 4 and the comparative example were manufactured, and their electrical characteristics were evaluated. The evaluation of the electrical characteristics was conducted using the transistors, and the results are as shown in Table 2 below.

**[Table 2]**

| | Vₜₕ [V] | µ_{FE} [cm²/Vs] | V_{hys} [V] | S.S. [mV/decade] |
|---|---|---|---|---|
| Comparative Example (C1) | 0.87 ± 0.05 | 31.71 ± 0.36 | 0.05 ± 0.01 | 77.94 ± 2.81 |
| Example 1 (S1) | 1.56 ± 0.04 | 31.44 ± 0.47 | 0.04 ± 0.01 | 80.16 ± 4.21 |
| Example 2 (S2) | -0.62 ± 0.06 | 54.5 ± 4.3 | 0.07 ± 0.01 | 64.8 ± 1.7 |
| Example 3 (S3) | 1.18 ± 0.06 | 31.74 ± 0.2 | 0.04 ± 0.00 | 64.78 ± 1.86 |
| Example 4 (S4) | -0.52 ± 0.20 | 33.79 ± 1.16 | 0.03 ± 0.01 | 79.39 ± 7.72 |

Referring to Table 2, as the ratio of the Sn deposition cycle increases, the hysteresis voltage (V_{hys}) does not significantly change. Additionally, mobility (µ_{FE}) characteristics are better when the Sn deposition cycle was conducted twice compared to the other cases.

Furthermore, as the ratio of the Sn deposition cycle increases, the subthreshold swing (S.S.) characteristics decrease and then increase. The S.S. characteristics of Examples 2 and 3, where the Sn deposition cycle was conducted two or three times, are improved almost to an ideal S.S. level of 60 mV/decade. On the contrary, the S.S. characteristics of Example 4, where the Sn deposition cycle was conducted five times, deteriorate.

The S.S. characteristics approximate the ideal S.S. level for the Sn contents of Examples 2 and 3. Accordingly, it can be inferred that when the ratio of Sn included in ITGO approaches the ratio of Sn included in Example 2 or 3, the S.S. characteristics can reach the ideal S.S. level.

For example, when the ratio of Sn among the metal elements included in each metal oxide thin film, i.e., Sn/(In+Sn+Ga), is between 10 at% and 30 at%, a semiconductor device can exhibit excellent S.S. characteristics.

Meanwhile, it was confirmed whether the characteristics of ITGO films would change depending on their deposition methods. Since the electrical characteristics of Example 2, where the Sn deposition cycle was conducted twice, were excellent, the characteristics of ITGO films, based on their deposition methods, were evaluated using Example 2.

### Production Example: Fabrication of ITGO Film According to Example 2

Using the method described above with reference to FIGS. 21 and 23, the ITGO film according to Example 2 was fabricated. That is, film B was fabricated using the ALD method.

### Comparative Example: Fabrication of ITGO Film

Using the method described above with reference to FIGS. 22 and 23, an ITGO film was fabricated. That is, film A was fabricated using the method described above with reference to FIGS. 22 and 23.

During the formation of one oxide semiconductor region ("110SR" of FIG. 5) in each of films A and B, the same numbers of Sn deposition cycles, In deposition cycles, and Ga deposition cycles were performed for both films A and B. In other words, if nine In deposition cycles were conducted during the formation of one oxide semiconductor region 110SR in film A, nine In deposition cycles were also conducted during the formation of one oxide semiconductor region 110SR in film B.

Film A may have a structure where indium oxide films, tin oxide films, and gallium oxide films are alternately stacked. Film B may have a structure where indium oxide films and gallium oxide films are alternately stacked. The indium oxide films in film B may be indium oxide films with Sn doped uniformly.

### Experimental Example 3: Composition Comparison of Metal Oxide Thin Films

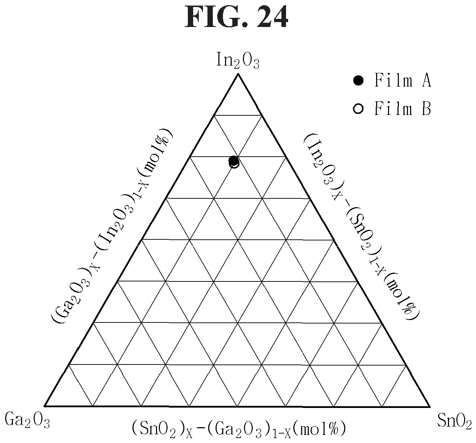

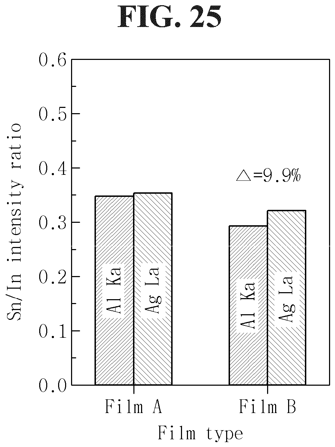

FIG. 24 is a diagram showing example compositions of thin films analyzed through X-ray fluorescence spectroscopy (XRF) according to some implementations. FIG. 25 is a diagram showing example compositions of thin films analyzed through X-ray photoelectron spectroscopy (XPS) according to some implementations.

In FIG. 24, the results of XRF analysis show that the overall composition of film A is almost identical to that of film B.

In FIG. 25, Al Kα X-rays (1.5 keV), which are soft X-rays, and Ag Lα X-rays (3.0 keV), which are hard X-rays, were used as sources for XPS. FIG. 25 shows the results of measurement at an angle of 30 degrees. For both films A and B, the Sn/In intensity ratio extracted using hard X-rays was found to be similar. However, the Sn/In intensity ratio extracted using soft X-rays, which are more sensitive to surfaces, was found to be lower than the Sn/In intensity ratio extracted using hard X-rays. This implies that in film B, the Sn element may be located deeper vertically than in film A. That is, in film B, Sn is uniformly doped within the indium oxide.

Through XRF and XPS, it was confirmed that the compositions of films A and B, deposited in different manners, could essentially be the same.

### Experimental Example 4: Defect Evaluation of Metal Oxide Thin Films

A defect characteristic evaluation was conducted for films A and B.

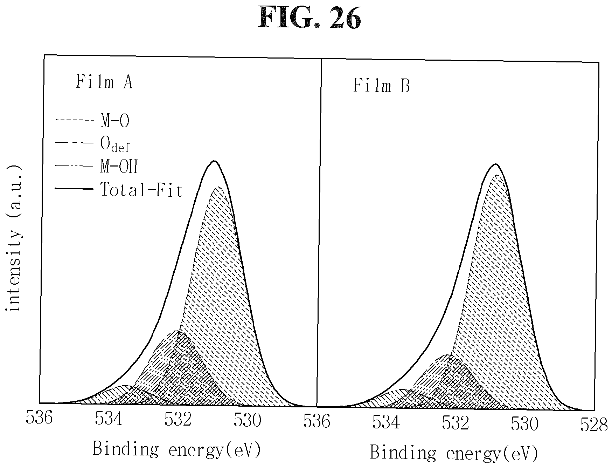

Through XPS analysis, the oxygen defect ratios (O_{def}) and metal hydroxide (M-OH) ratios within films A and B were measured, and the results are as presented in Table 3 below and FIG. 26.

**[Table 3]**

| | O-M | O_{def} | M-OH |
|---|---|---|---|
| Film A | 69.9 | 24.0 | 6.1 |
| Film B | 76.0 | 17.6 | 6.4 |

FIG. 26 is a graph showing an example of XPS analysis results for the metal oxide thin films according to Experimental Example 4 according to some implementations. In FIG. 26 and Table 3, the oxygen defect (O_{def}) ratio is lower in film B than in film A. Additionally, the metal-oxygen (M-O) ratio is higher in film B than in film A.

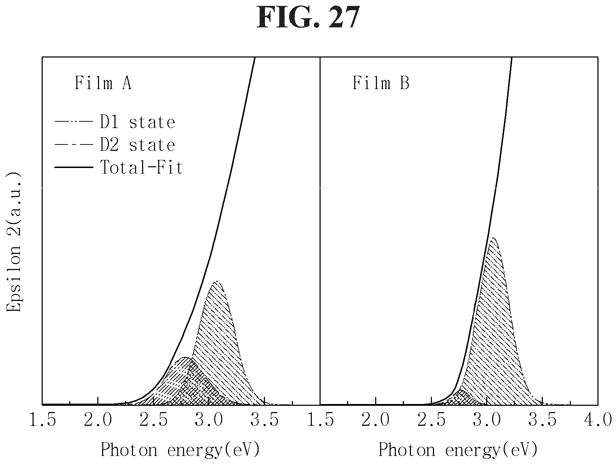

Spectroscopic ellipsometry (SE) analysis was conducted to measure the defect ratios within films A and B, and the results are as presented in Table 4 below and FIG. 27.

**[Table 4]**

| | D1 State | D2 State |
|---|---|---|
| Film A | 71.2 | 31.6 |
| Film B | 85.7 | 3.8 |

FIG. 27 is a graph showing an example of SE analysis data for films A and B according to some implementations. The SE analysis data were separated into two sub-gap states, i.e., states D1 and D2. State D1 may indicate carrier-related defects, and state D2 may indicate oxygen-related defects. Referring to FIG. 27, the ratio of state D1 is greater in film B than in film A. Conversely, the ratio of state D2 is less in film B than in film A. Accordingly, it can be inferred that oxygen defects are reduced in film B compared to film A. Additionally, film B exhibits an increased carrier concentration compared to film A.

### Experimental Example 5: Evaluation of Characteristics of Devices Containing Metal Oxide Thin Films

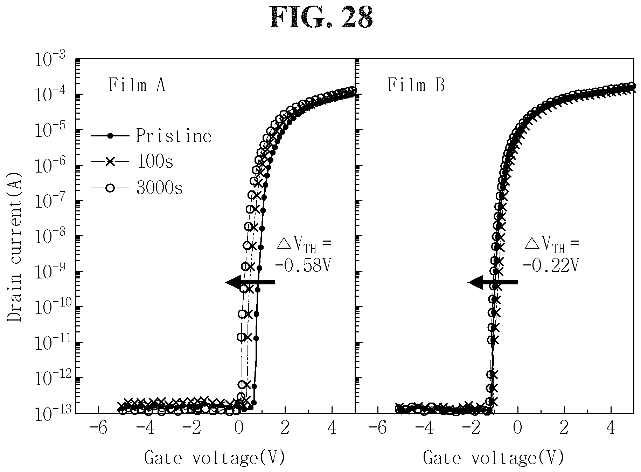

Transistors, having films A and B as channel layers, were manufactured, and their electrical characteristics were evaluated. Specifically, the electrical characteristics of the transistors were assessed, and the results are as shown in Table 5 below. The photo reliability of the transistors was also evaluated, and the results are as presented in FIGS. 28 to 31.

**[Table 5]**

| | Vₜₕ [V] | µ_{FE} [cm²/Vs] | V_{hys} [V] | S.S. [mV/decade] |
|---|---|---|---|---|
| Film A | 0.86 ± 0.08 | 41.9 ± 3.3 | 0.06 ± 0.02 | 69.8 ± 1.5 |
| Film B | -0.62 ± 0.06 | 54.5 ± 4.3 | 0.07 ± 0.01 | 64.8 ± 1.7 |

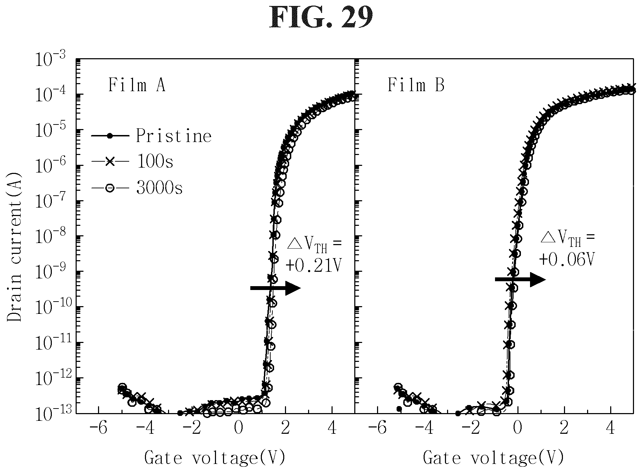

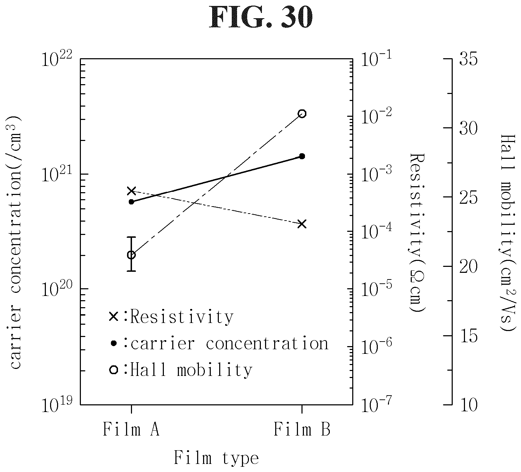

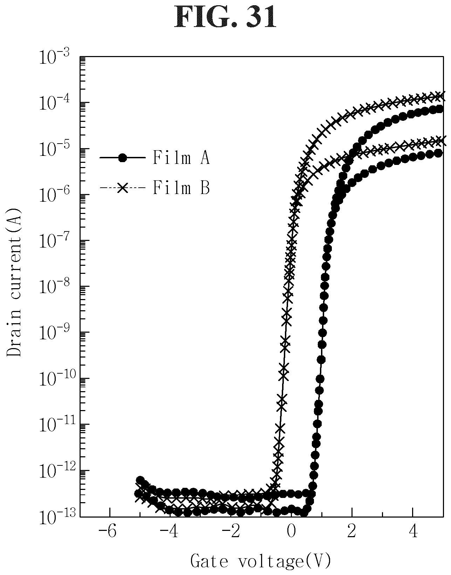

FIGS. 28 and 29 are graphs showing example results of the photo reliability evaluation for the transistors according to Experimental Example 5 according to some implementations. FIG. 30 is a graph showing example electrical characteristic evaluation results for films A and B according to some implementations. FIG. 31 is a graph showing example electrical characteristic evaluation results for the transistors according to Experimental Example 5 according to some implementations.

Referring to Table 5, the mobility (µ_{FE}) of film B is higher than that of film A. Moreover, the S.S. of film B is closer than that of film A to the ideal S.S. level. This implies that the deposition method of an ITGO film does not significantly affect the hysteresis voltage (V_{hys}) of the ITGO film.

FIG. 28 shows example results of a negative bias illumination stress (NBIS) test. The NBIS test was conducted by applying an electric field of -2 MV/cm to the transistors according to Experimental Example 5 while irradiating them with light at 1000 lux. Referring to FIG. 28, film B exhibits a 61% improvement over film A.

FIG. 29 shows example results of a positive bias temperature stress (PBTS) test. The PBTS test was conducted by applying an electric field of +2 MV/cm to the transistors according to Experimental Example 5 while maintaining a temperature of 95°C. Referring to FIG. 29, film B demonstrates a 71% improvement over film A.

Photo reliability may be closely related to oxygen defects (O_{def}). As shown in FIGS. 26 and 27 and Tables 3 and 4, film B exhibits suppressed oxygen defects compared to film A.

FIG. 30 shows that film B has an improved hall mobility and carrier concentration, as well as reduced resistance, compared to film A, and FIG. 31 shows that the threshold voltage (Vₜₕ) of a transistor fabricated using film B can be improved compared to a transistor fabricated using film A.

Films A and B may have substantially the same thin film composition. Moreover, films A and B can both be formed using the ALD method. However, films A and B may differ in how indium oxide and tin oxide are deposited therein.

In film A, indium oxide is continuously deposited, and then tin oxide is continuously deposited. In contrast, in film B, indium oxide and tin oxide are alternately formed. In other words, in film B, tin oxide may be formed as a doping film uniformly doped within indium oxide. By forming tin oxide as a doping film within indium oxide, Sn can be uniformly distributed within an indium oxide film. The high electron affinity of Sn within the indium oxide film can suppress the formation of oxygen vacancies within indium oxide. The reduction of such oxygen vacancies can enhance the performance and reliability of a semiconductor memory device. While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor memory device comprising:
a substrate;
a bitline extending in a first direction on the substrate;
a first channel pattern disposed on the bitline;
a second channel pattern disposed on the bitline and spaced apart from the first channel pattern in the first direction;
a first wordline disposed between the first channel pattern and the second channel pattern and extending in a second direction;
a second wordline extending in the second direction, disposed between the first channel pattern and the second channel pattern, and spaced apart from the first wordline in the first direction; and
a first capacitor and a second capacitor disposed on and connected to the first channel pattern and the second channel pattern,
wherein each of the first channel pattern and the second channel pattern includes a first metal oxide pattern that comprises indium (In), gallium (Ga), and tin (Sn),
wherein, in a composition distribution of the first metal oxide pattern, positions of In peaks differ from positions of Ga peaks, and
wherein, in the composition distribution of the first metal oxide pattern, a number of the In peaks differs from a number of the Ga peaks.

2. The semiconductor memory device of claim 1, wherein the number of the In peaks is greater than the number of the Ga peaks.

3. The semiconductor memory device of claim 2, wherein a content of In included in the first metal oxide pattern is greater than a sum of contents of Sn and Ga included in the first metal oxide pattern.

4. The semiconductor memory device of claim 1,
wherein the first wordline includes first portions and second portions that are arranged alternately in the second direction, and
wherein a width, in the first direction, of the first portions of the first wordline is less than a width, in the first direction, of the second portions of the first wordline.

5. The semiconductor memory device of claim 4,
wherein the first channel pattern is closer to the first wordline than to the second wordline, and
wherein the first channel pattern is disposed between second portions of the first wordline that are adjacent to each other in the second direction.

6. The semiconductor memory device of claim 1, further comprising:
a gate insulating film disposed between the first channel pattern and the first wordline,
wherein a height from the bitline to an uppermost part of the gate insulating film is greater than a height from the bitline to an uppermost part of the first channel pattern.

7. The semiconductor memory device of claim 1,
wherein each of the first channel pattern and the second channel pattern further includes a second metal oxide pattern that is disposed between the first metal oxide pattern and the bitline,
wherein the second metal oxide pattern comprises In and Sn, and
wherein the second metal oxide pattern excludes Ga.

8. The semiconductor memory device of claim 1, further comprising:
a gate separation pattern disposed on the bitline and separating the first wordline and the second wordline,
wherein the first channel pattern and the second channel pattern are connected by a connecting channel pattern, and
wherein the gate separation pattern is disposed on the connecting channel pattern.

9. The semiconductor memory device of claim 1, further comprising:
a gate separation pattern disposed on the bitline and separating the first wordline and the second wordline,
wherein the gate separation pattern contacts the bitline.

10. The semiconductor memory device of claim 1, further comprising:
a protruding insulating pattern disposed on the bitline,
wherein the first channel pattern includes vertical portions that extend along sidewalls of the protruding insulating pattern and a horizontal portion that extends along an upper surface of the bitline.

11. A semiconductor memory device comprising:
a substrate;
a bitline extending in a first direction on the substrate;
a protruding insulating pattern disposed on the bitline and including a channel trench that extends in a second direction that intersects the first direction;
a channel structure disposed on the bitline within the channel trench;
a first wordline disposed on the channel structure and extending in the second direction;
a second wordline disposed on the channel structure, extending in the second direction, and spaced apart from the first wordline in the first direction; and
capacitors disposed on the channel structure and connected to the channel structure,
wherein the channel structure includes a first metal oxide pattern that includes a plurality of oxide semiconductor regions,
wherein each of the oxide semiconductor regions comprises indium (In), gallium (Ga), and tin (Sn),
wherein each of the oxide semiconductor regions extend along sidewalls and a bottom surface of the channel trench, and
wherein, in a composition distribution of the first metal oxide pattern, each of the oxide semiconductor regions comprises a plurality of In peaks.

12. The semiconductor memory device of claim 11,
wherein each of the oxide semiconductor regions comprises a Ga-rich region and an In-rich region that extend along the sidewalls and the bottom surface of the channel trench, and
wherein the In-rich region comprises Sn.

13. The semiconductor memory device of claim 12, wherein the In-rich region includes the plurality of In peaks.

14. The semiconductor memory device of claim 11,
wherein the channel structure further includes a second metal oxide pattern that is disposed between the first metal oxide pattern and the bitline,
wherein the second metal oxide pattern comprises In and Sn, and
wherein the second metal oxide pattern excludes Ga.

15. A semiconductor memory device comprising:
a substrate;
a periphery gate structure on the substrate;
a bitline disposed on the periphery gate structure and extending in a first direction;
a channel structure disposed on the bitline, the channel structure including a horizontal portion and first and second vertical portions that protrude from the horizontal portion;
a first wordline disposed on the channel structure and extending in a second direction;
a second wordline disposed on the channel structure, extending in the second direction, and spaced apart from the first wordline in the first direction;
a gate separation pattern disposed on the horizontal portion of the channel structure and separating the first wordline and the second wordline;
landing pads disposed on the channel structure and connected to the channel structure; and
data storage patterns disposed on the landing pads,
wherein the channel structure includes a first metal oxide pattern that comprises indium (In), gallium (Ga), and tin (Sn),
wherein a ratio of Sn among metal elements included in the first metal oxide pattern is between 10 at% and 30 at%, and
wherein, in a composition distribution of the first metal oxide pattern, a ratio of a number of In peaks to a number of Ga peaks is 2 or greater.
